Europäisches Patentamt

European Patent Office

Office européen des brevets

(19)

(11) Publication number: **0 219 703 B1**

(12) **EUROPEAN PATENT SPECIFICATION**

(45) Date of publication of patent specification: **22.05.91**

(51) Int. Cl.⁵: **H03J 9/06**, H04N 5/44, H03J 5/02

(21) Application number: **86113039.1**

(22) Date of filing: **22.06.82**

(60) Publication number of the earlier application in accordance with Art.76 EPC: **0 068 422**

(54) Improved television receiver.

(30) Priority: **29.06.81 IT 6789281**
**09.03.82 IT 6727482**

(43) Date of publication of application:
**29.04.87 Bulletin 87/18**

(45) Publication of the grant of the patent:
**22.05.91 Bulletin 91/21**

(84) Designated Contracting States:
**DE FR GB IT NL**

(56) References cited:
**DE-A- 2 850 392**
**DE-A- 2 911 102**
**FR-A- 2 430 149**
**US-A- 4 270 145**

**IEEE TRANSACTIONS ON CONSUMER ELEC-TRONICS, vol. CE-24, no. 3, August 1978, pages 436-441, IEEE, New York, US; C. CLIF-FORD et al.: "Microprocessor based, soft-ware defined television controller"**

(73) Proprietor: **Società Italiana per lo Sviluppo dell'Elettronica S.I.SV.EL S.p.A.
Via Pinerolo 23
I-10060 None (TO)(IT)**

(72) Inventor: **Belisomi, Pietro
Viale Rimembranza, 50
I-10064 Pinerolo(IT)**
Inventor: **Farina, Attilio
Via Ventimiglia, 162
I-10127 Torino(IT)**

## Description

The present invention relates to a television receiver comprising a control unit connected to circuit means for controlling the display of alphanumerical characters, connected to television signal tuning means, to first electronic memorising means for memorising at least data relative to the tuning of said television signals, and to an operating unit for receiving data from the user.

The known prior art television sets are designed to perform various functions (for example, the direct channel selection, the memorisation of a large number of programs, the time display, the timed turn-on or program switching, etc.) which can be easily performed with the aid of a suitably programmed microprocessor.

Television sets (see for example US-A-4270145) may be provided with an alphanumerical character display device, for supplying data functions; for example a device comprising means for the reproduction of alphanumerical data on display screen or a printing device. These display devices are usually only designed to provide a numerical indication of the time, channel and/or program, and the keyboard means by means of which the said functions are controlled possess a limited number of keys which cannot allow a large number of operations on the set.

It is also known, for example by the published German Patent Application DE-A-2 911 102, to use a television receiver, together with a keyboard, a telephone set, a data Bank or a computer, to retrieve data from a suitable data source.

The object of the present invention is to provide a television set which could perform more sophisticated functions than the prior art comparable sets, with no substantial increase in the complexity and cost of the circuits, functions which normally could be obtained only at a major cost by means of computers. Therefore, on the ground of the present invention there is provided a television receiver comprising a control unit connected to circuit means for controlling the display of alphanumerical characters, connected to television signal tuning means, to first electronic memorizing means for memorizing data relative to the tuning of said television signals, and to an operating unit for receiving data from the user, characterized in that said operating unit comprise means to generate an alphanumerical set of characters, that additional groups of cells in said first electronic memorizing means are provided to memorize a plurality of alphanumerical identifying labels, each one composed of a plurality of characters, that at least one group of cells in said first memorizing means, containing said data relative to the tuning of a television signal, can be associated with a correspondent additional group of cells in said first memorizing means, containing one of said identifying labels, and that in response to a first coded control signal coming from said operating unit and corresponding to one of said identifying labels, the said control unit searches said additional groups of cells in said first memorizing means and extracts from the corresponding one group of cells the data relative to the tuning of said television signal and sends them to the said tuning means, in order to correctly tune the said station, and supplies the said circuit means with codes apt to obtain the display of the said identifying label.

The invention will now be described in detail, in order to render easy its realization, in particular with reference to the annexed drawings given by way of non-limiting example.

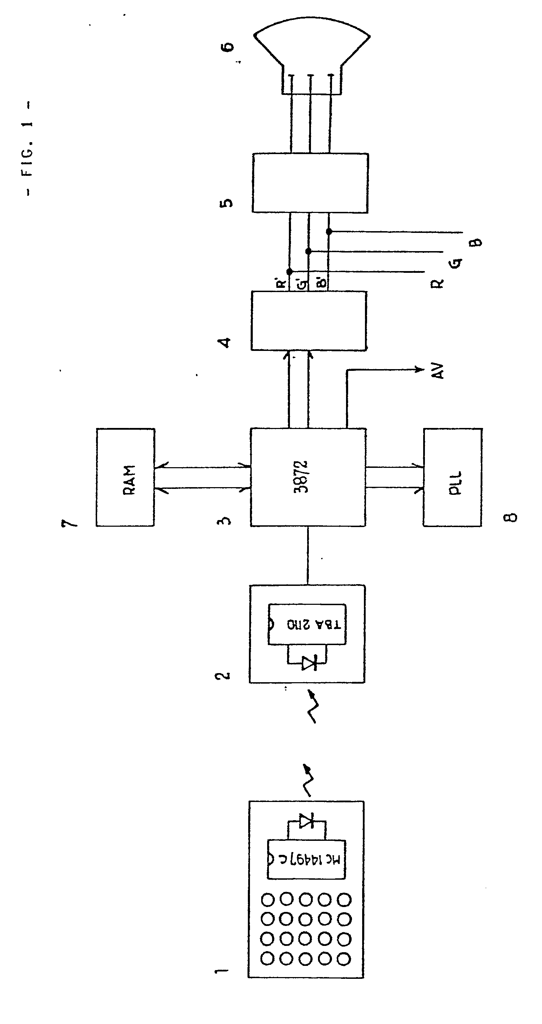

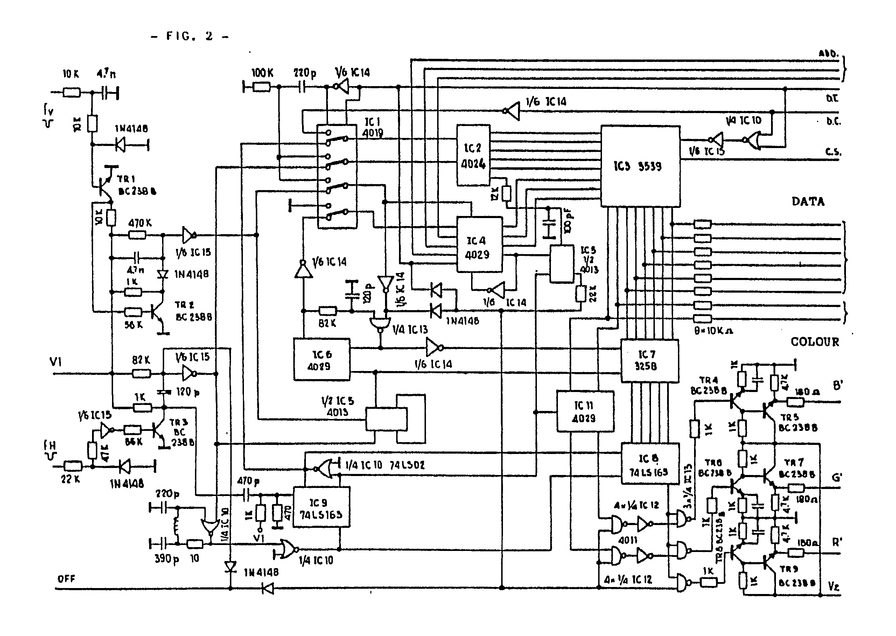

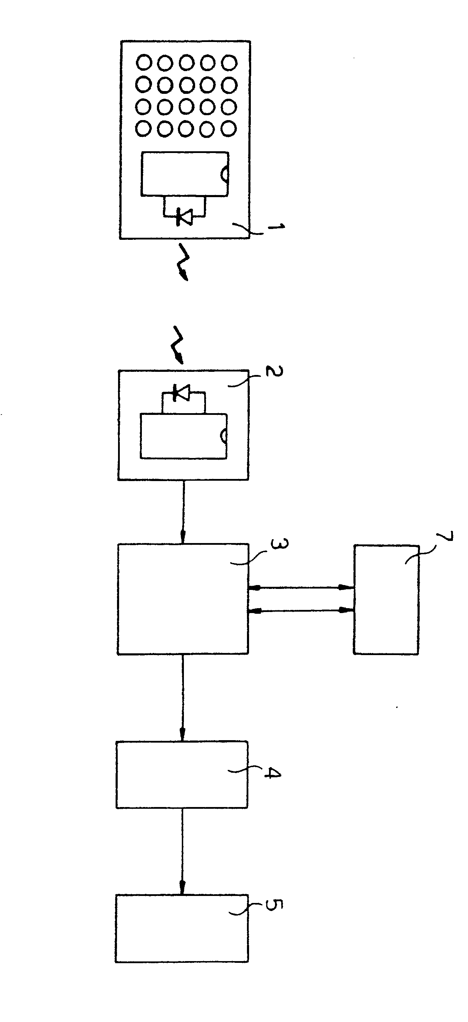

Figure 1 shows a block diagram of a television set improved according to the present invention; figure 2 shows a wiring diagram of some of the circuits diagrammatically shown in Fig. 1; figures 3, 4, 5, 6, 7, 8, 9, 10, 11, 12, 13, and 14 show block diagrams of the elementary functions performed by the circuits inserted inside the television set according to the invention and figure 15 shows a block diagram of a different embodiment of a set according to the present invention.

In Fig. 1, reference numeral 1 indicates a remote control transmitter comprising an alphanumerical keyboard composed conveniently of 64 keys and known infrared ray transmission and coding circuits (Motorola MC 14497 integrated circuit). Number 2 is an infrared ray receiver circuit comprising an amplifier (Motorola TBA 2110 integrated circuit) whose output is connected to control unit 3 comprising a Fairchild 3872 integrated circuit (microcomputer).

The control unit is also connected to :
- a RAM CMOS memory (7) consisting of 512 8-bits-cells and made using two RCA MW 5113 512x4 RAM memories;
- a PLL frequency synthesis circuit (8) for direct channel tuning consisting of a Motorola UAA 2000 integrated circuit;
- a character generating circuit (4) for displaying 64 types of alphanumerical characters on the screen with a 5x7 dot matrix, arranged in 8 lines of 32 characters each;
- the "AV" terminal of a known time constant switch circuit for the line sync circuits on the receiver.

The character generating circuit has 3 outputs (R', G', B') connected to inputs R, G, B respectively on final video circuit 5. The latter also receives at inputs R, G, B the three red, green, and blue colour signals sent out from the brightness and colour circuits on the set and has three outputs connected to the cathodes of colour kinescope 6.

More detailed information about the integrated and associated operating circuits mentioned above and later on can be found in the maker's specifications and catalogues which are readily available on the market.

Operation of the circuit is as follows:

Remote control transmitter 1 consists of:

- a first set of 32 dual function buttons, the first or second function being selected by means of a "shift" key; the first set of functions includes the letters of the alphabet and the second the numbers and punctuation marks;
- three keys TAC, CAL, DSP for selecting the required function: scratch pad, calendar, return to normal receiver functions control;
- eight control keys for compiling the scratch pad message;
- an OFF key for switching the set off.

When any one of these 44 keys is pressed, the MC 14497 integrated circuit transmits a special signal in two-phase FSK code, i.e. a series signal consisting of two packs of two given frequencies for each bit in the number of the key that has been pressed. Receiver amplifier circuit 2 than amplifies and demodulates the received signal into a time sequence of logic ones and zeroes. Whenever a key is released, integrated circuit MC 14497 automatically transmits an end-of-transmission code corresponding to control 63.

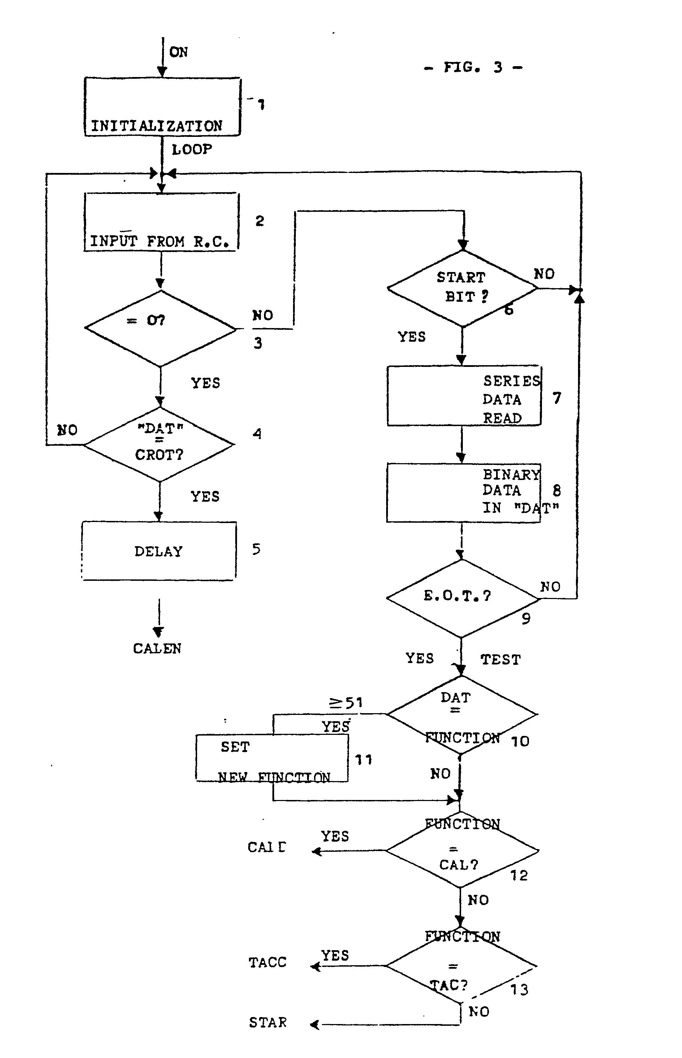

Control unit 3 decodes the said time sequence into the corresponding code of the key that has been pressed. When one of the TAC, CAL or DSP function keys is pressed, the control unit switches to corresponding operating mode as described later on with reference to FIG. 3.

If the TAC key is pressed, the control unit calls up data (scratch pad message) from memory circuits 7 and sends it to character generating circuit 4 for display on the screen, after which it prepares to receive further instructions from the transmitter, instructions which it memorises in RAM 7 for forming a new message.

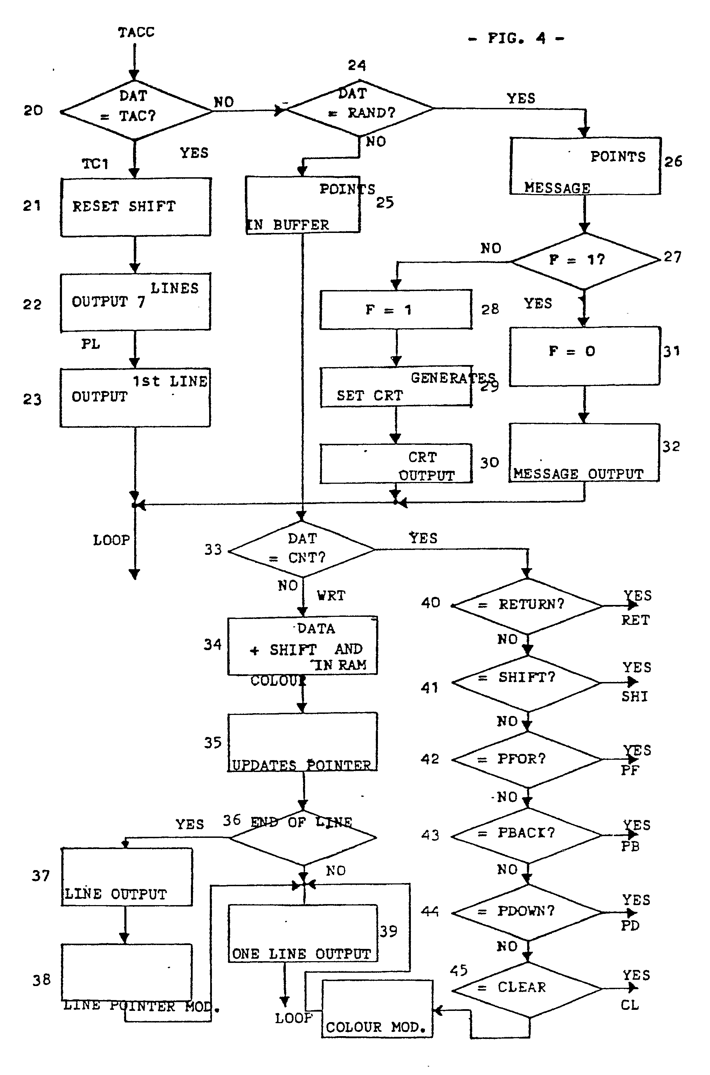

More details will be given about this when we get to Figs 4, 5, 6 and 7.

If the CAL button is pressed, the control unit sends character generating circuit 4 the following message:

"CALENDAR OF ??/????"

and prepares to receive the number of the month (January = 01, December = 12) and calendar year in question. Once this data has been supplied, the control unit calculates the date of the first day in the month requested, draws up a seven-column table of 4 or 5 lines showing all the days in the month and sends it to character generating circuit 4. The calendar displayed on the screen may look like this:

DECEMBER 1980

| MO | TU | WE | TH | FR | SA | SU |
|----|----|----|----|----|----|----|
| 1  | 2  | 3  | 4  | 5  | 6  | 7  |
| 8  | 9  | 10 | 11 | 12 | 13 | 14 |
| 15 | 16 | 17 | 18 | 19 | 20 | 21 |
| 22 | 23 | 24 | 25 | 26 | 27 | 28 |
| 29 | 30 | 31 |    |    |    |    |

The month and year (DECEMBER 1980) are displayed in red, the days of the week (MO ... SA) in magenta, the numbers usually in white and "SU" and public holiday numbers (7, 14, 21, 28, 8, 25, 26) in red.

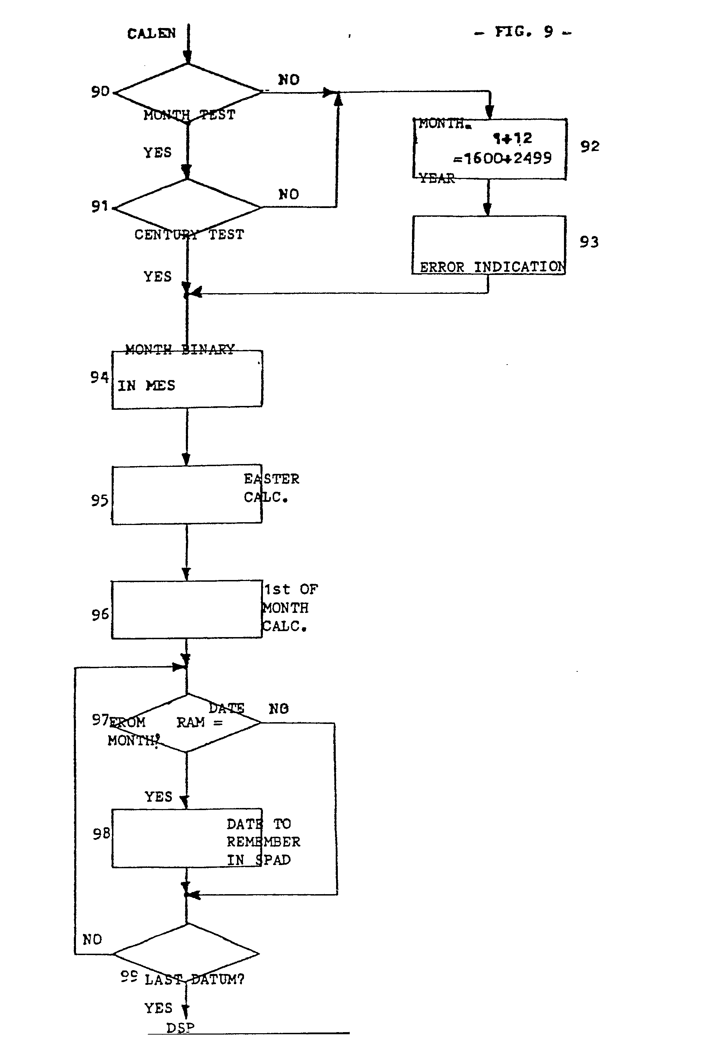

More detailes about this will be given later when we get to Figs 8, 9 and 10.

If the DSP button is pressed, the control unit prepares for ordinary television functions (channel/programme selection, level adjustments, memorisation, etc.).

In the case of programme selection, for example, the control unit calls up tuning data relative to the selected programme number from RAM memory 7, calculates the dividing number, which it sends in code to PLL circuit 8 for tuning into the required channel, and sends the data to be displayed (selected programme/channel number, etc.) to character generating circuit 4; for certain programmes, it also supplies terminal "AV" with a time constant switch signal.

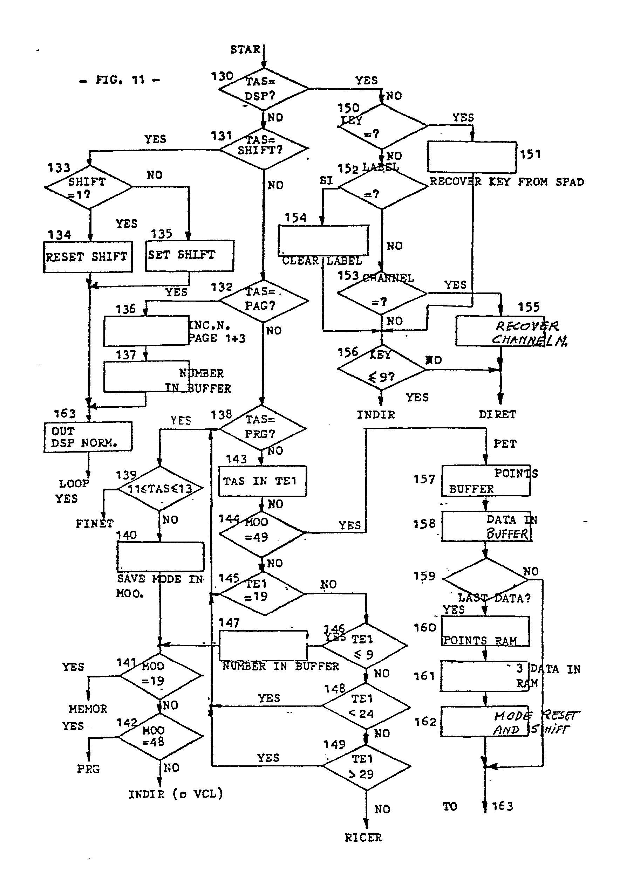

The way some of these functions are controlled by the present invention will be described in more detail when we get to Figs 11, 12, 13 and 14, particularly as regards memory labels for identifying priority stations.

The non-volatile RAM memory 7 or, as in the case described, the low consumption CMOS memory, with a buffer battery for preserving data even in the event of power failure, is used for memorising both scratch pad and favourite programme data in specific separate areas. Scratch pad data in 32x8 = 256 cells, i.e. the first half of the memory and programme data in 8x10x3 = 240 cells (8 data per programme on 3x10 = 30 programmes in 3 pages of 10) in the second half of the memory. Besides the external RAM memory 7, the control unit microcomputer contains a block of registers (SPAD), consisting of (64) 8-bit registers, and a RAM memory area (BUFFER), consisting of 64 RAM memory cells ranging between the FCO and FFF addresses in hexadecimal notation.

Operation of character generating circuit 4, connected to kinescope 6 via final video amplifier circuit 5, will now be described with reference to Fig. 2.

"DATA" indicates 6 input terminals representing the ASCII code of the 64 symbols which may be displayed.

"COLOUR" indicates 2 terminals representing the particolar colour assigned to each character (00 = RED, 10 = YELLOW, 01 = MAGENTA, 11 = WHITE).

"ADD" indicates 3 terminals representing the selected print line number (0-7 on 8-line display).

"DT" indicates a clock terminal for moving the character forward on a given line.

"FH" and "FV" indicate 2 sync terminals, one horizontal- and the other vertical-frequency, depending on the scanning of the set.

"R', G', B'" indicate 3 output terminals for supplying red, green and blue display picture data which is amplified and then sent to the kinescope.

The said character generating circuit essentially consists of a Fairchild 3258 integrated circuit for generating a 64-character display matrix, a Fairchild 3529 256x8 RAM memory, a clock generator consisting of Fairchild IC10 (74LS02) and IC9 (74LS163) integrated circuits and character and line counters, for supplying addresses to the memory circuit, consisting of Fairchild IC2 (4024) and IC4 (4029) integrated circuits with the auxiliary circuits and connections shown in Fig. 2.

Operation of the circuit is as follows:

For printing on a given line, the line number must first be sent to the "ADD" terminals so as to set the line counter to the required value. A signal is then sent to the "DT" terminal for setting the memory to print mode, followed by the display character and clock pulse which are sent respectively to the "DATA", "COLOUR" and "DC" terminals.

The entered data is thus memorised in successive memory cells in the area set aside for the selected line.

The above operation is repeated in the case of multiple lines and, once all the data has been loaded, the characters stored in the memory are displayed by removing the signal on the "DT" terminal.

This causes the cells on the RAM memory to be scanned, in time with the vertical- and horizontal-frequency signals on the set, the content of which (6 bits corresponding to the ASCII code of the character in question) is sent to the input of character generating integrated circuit 3258. This then sends out 5 signals, corresponding to the 5 picture elements making up a line on the 5x7 character matrix, which are converted into a series signal by the parallel-series converter, consisting of a Fairchild IC8 (74LS165) integrated circuit, which is then sent to one or more of outputs R', G', B' depending on the two colour bits.

The character generating circuit has another two input terminals ("CS" and "OFF") - one for print enabling the character generator RAM memory and the other for disabling any printing on the screen - both connected to appropriate outputs on the microcomputer control unit.

Operation of the latter is shown in the block diagrams of its basic functions.

Fig. 3 shows reading and decoding of the controls received from amplifier 2 in Fig. 1 and function selection. Number 1 in Fig. 3 indicates an initialization block which, when activated by an "ON" signal, assigns specific initial values to the registers and TIMER and arranges for the "receiver control" function.

The initialization block activates the next block (2) which reads the input signal from amplifier 2 in Fig. 1 and, in turn, activates block 3 which checks whether the signal is 0.

The "YES" output of block 3 activates block 4 which checks whether the "DAT" register contains a preset "CROT" value.

The "NO" output of block 4 supplies the signal for activating block 2 while the "YES" output activates block 5, which, after a set pause, supplies a "CALEN" signal for activating the blocks in Fig. 9.

The "NO" output of block 3 activates the next block (6) which checks whether the input signal contains a START bit The "NO" output of block 6 supplies the signal for activating block 2 while the "YES" output of block 6 activates in turn:
- block 7 which reads the series signal received from amplifier 2 in Fig. 1;
- block 8 which converts the read data into a binary number and memorises it in the "DAT" register;
- block 9 which detects the presence of an end-of-transmission signal ("EOT").

The "NO" output of block 9 supplies the signal for activating block 2, while the "YES" output activates block 10 which checks whether the "DAT" register contains a set of "FUNCTION" (code greater than 50) values. The "YES" output activates block 11, which arranges for the new function and memorises the content of the "DAT" register in the "FUNCTION" register, while the "NO" output of block 10 and the output of block 11 activate in turn:
- block 12 which checks whether the "FUNCTION" register contains a prearranged "CAL" value corresponding to the code of the calendar key on keyboard 1 in Fig. 2;
- block 13 which checks whether the "FUNCTION" register contains a prearranged "TAC" value corresponding to the code of the scratch pad key on keyboard 1 in Fig. 2.

The "YES" output of block 12 supplies a "CALE" signal for activating the blocks described later in Fig. 8. The "YES" output of block 13 supplies a "TACC" (scratch pad) signal for activating the blocks described later in Fig. 4, while the "NO" output supplies a "STAR" signal for activating the television function control blocks described later in Fig. 11.

Fig. 4 shows a block diagram of the basic "TACC" logic functions performed by the control unit.

The "TACC" signal received from block 13 in Fig. 3 activates block 20 which checks whether the "DAT" register contains a prearranged "TAC" value (i.e. whether the scratch pad function key has just been pressed on keyboard 1 in Fig. 1).

The "YES" output (first time) activates in turn:
- block 21 which zeroes the shift mode (sets the keys in the first character group, i.e. letters of the alphabet);
- block 22 which supplies character generating circuit 4 in Fig. 1 with the data stored in RAM memory 7 in Fig. 1 corresponding to the last 7 lines of characters forming the scratch pad message;
- block 23 which supplies the character generating circuit 4 with first line data and positions the "pointer" character in the first top left-hand position on the screen.

Block 23 then supplies an enabling (LOOP) control to block 2 in Fig. 3. The "NO" output of block 20 activates block 24, which checks whether the "DAT" register contains a prearranged "RAND" value, while the "YES" output of block 24 activates in turn:
- block 26, which sets a pointer at the start of the message in the form of a set of codes stored in the ROM memory on the microcomputer;
- block 27 which checks for an "F" signal.

The "YES" output of block 27 then activates block 31 which clears the "F" signal and block 32 which sends the ROM code sequence to the character generating circuit 4.

The "NO" output of block 27 activates in turn:
- block 28 which generates the "F" signal;
- block 29 which generates all the codes representing all the characters that can be generated by the character generating circuit 4;
- block 30 which sends the generated codes to the character generating circuit 4.

Blocks 30 and 32 supply the enabling signal to block 2 in Fig. 3.

The "NO" output of block 24 activates block 25, which, depending on the line number ("ADD" register) and pointer position ("CRT" register), sets the pointer to a particular cell in RAM memory 7 in Fig. 1.

Block 25 activates block 33 which checks whether the content of the "DAT" register belongs to the group of control function values (greater than 50).

The "NO" output (data for display) activates in turn:
- block 34, which adds a shift function bit and two colour bits to the content of the "DAT" register and memorises the new data in the RAM memory;
- block 35, which alters the content of the "CRT" register (pointer position);
- block 36, which checks whether the position of the pointer corresponds to the end of a line.

The "YES" output of block 36 activates in turn block 37, which sends all the line data to the character generating circuit 4, and block 38, which alters the content of the "ADD" register (line pointer).

The "NO" output of block 36 and block 38 activate block 39, which sends the new line data to the character generating circuit 4 and an enabling signal to block 2 in Figs. 3.

The "YES" output of block 33 activates in turn:
- block 40, which checks whether the "DAT" register contains a prearranged "RETURN" value (new

5

EP 0 219 703 B1

line key clearing all the remaining characters on the present line);
- block 41, which checks whether the "DAT" register contains a prearranged "SHIFT" value (key for selecting first or second case for the first 32 keys on the keyboard);
- block 42, which checks whether the "DAT" register contains a prearranged "PFOR" value (pointer forward shift key);
- block 43, which checks whether the "DAT" register contains a prearranged "PBACK" value (pointer backward shift key);
- block 44, which checks whether the "DAT" register contains a prearranged "PDOWN" value (key for shifting the pointer to the start of the next line);
- block 45, which checks whether the "DAT" register contains a prearranged "CLEAR" value (key for clearing the page starting from the present position);
- block 46, which alters the data (0-3) in the colour register.

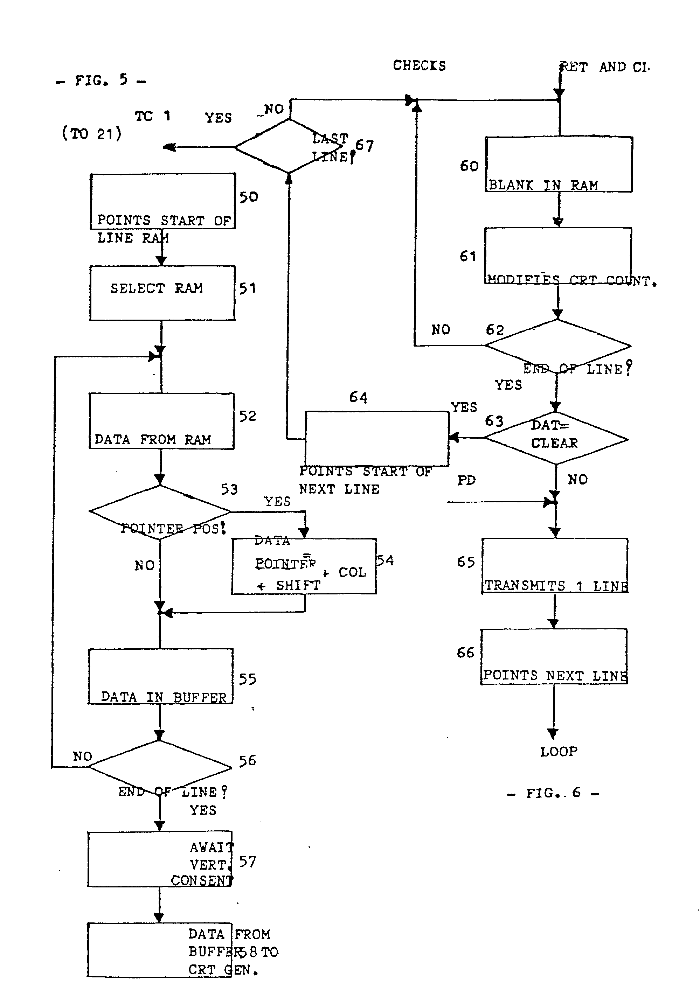

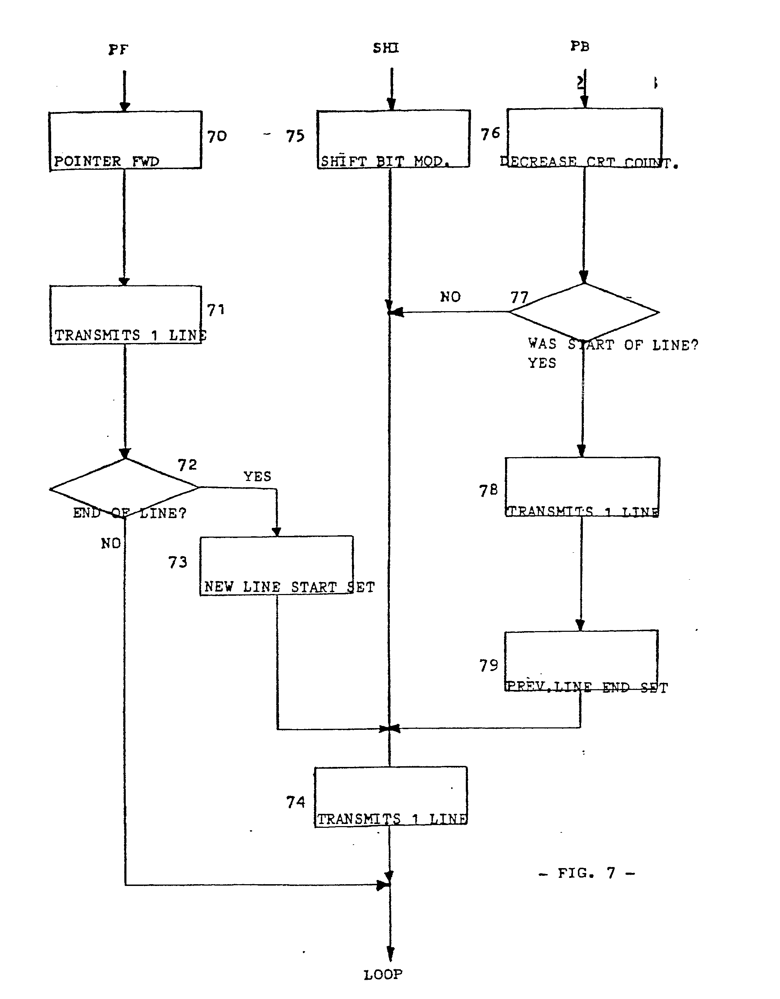

The "YES" outputs of blocks 40, 41, 42, 43, 44 and 45 supply signals "RET", "SHI", "PF", "PB", "PD", and "CL" respectively for enabling the next blocks in Figs 5, 6 and 7. Block 46 supplies the activating signal to block 39.

Fig. 5 shows the reading of a line in RAM memory 7 of Fig. 1 and transmission to the character generating circuit 4, i.e. operation of Fig. 4 blocks, such as 22, 23, 37 and 39, in greater detail.

Number 50 in Fig. 5 indicates a block which, depending on the present line number in the "ADD" register, initialises a pointer register at a given cell on RAM memory 7 in Fig. 1.

The said block activates in turn:
- block 51, which enables the RAM memory for reading;
- block 52, which reads data from the said memory;
- block 53, which checks whether the position of the character that has just been read tallies with the position of the pointer.

The "YES" output of block 53 activates block 54, which substitutes the read data with a selected pointed character code ("_" = 31) and adds the colour and shift bits.

The "NO" output of block 53 and the ouput of block 54 activate in turn:
- block 55, which copies the data into a memory BUFFER inside the microcomputer control unit;
- block 56, which checks whether the read data is the last of a print line.

The "NO" output of block 56 supplies an enabling signal to block 52, while the "YES" output of block 56 enables block 57, which waits for a vertical-frequency sync pulse, after which it supplies an enabling signal to block 58, which transfers the line data stored in the BUFFER to the character generating circuit 4.

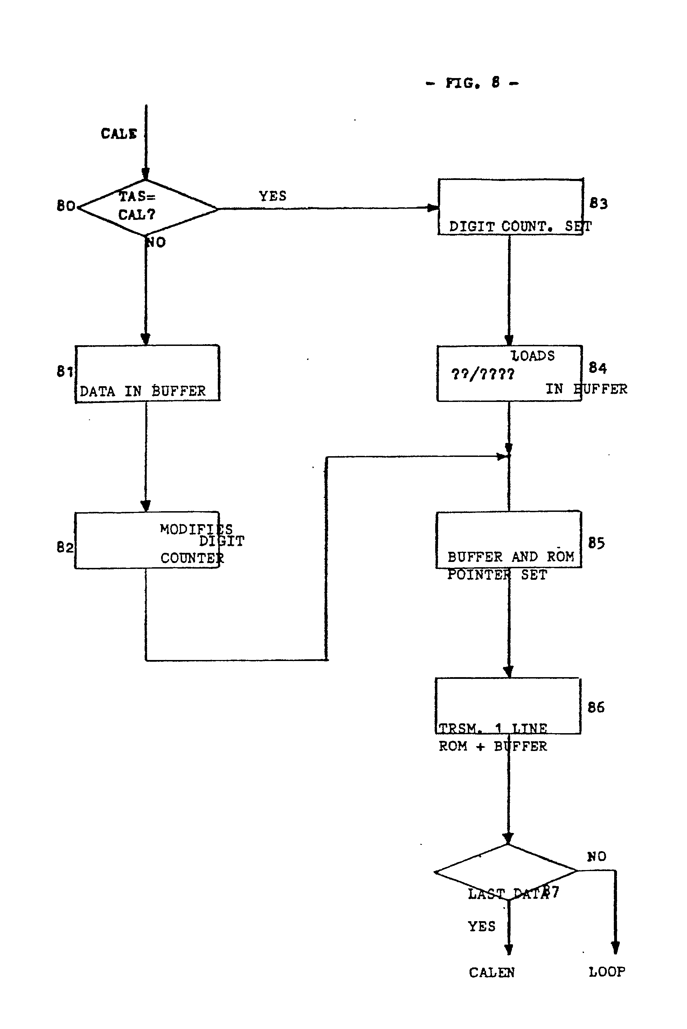

Figs 6 and 7 show block diagrams of the elementary functions performed by the microcomputer control unit for controlling composition of the printed text.

Fig. 6 shows the page clearing functions and pointer shift with or without clearing and Fig. 7 the shift function and pointer shift to the right or left.

The "RET" or "CL" signal in Fig. 6, supplied by blocks 40 and 45 in Fig. 4, activates in turn:
- block 60, which sends the "BLANK" character code to RAM memory 7 in Fig. 1;
- block 61, which modifies pointer position counter "CRT";
- block 62, which checks whether the position corresponds with the end of a line.

The "NO" output of block 62 supplies an enabling signal to block 63, which checks whether the "DAT" register contains a prearranged "CLEAR" value (clear key); the "YES" output activates block 64, which modifies the pointer registers to indicate the start of the next line and activates block 67, which checks whether the end of the last line has been reached; the "YES" output supplies signal "TC1" to block 21 in Fig. 4, while the "NO" output supplies an enabling signal to block 60.

The "NO" output activates in turn:
- block 65, which transmits a line of data to the character generating circuit 4;
- block 66, which points to the start of the next line and supplies an enabling signal to block 2 in Fig. 3 (await new data).

The "PF" signal in Fig. 7 from block 42 in Fig. 4 activates in turn:
- block 70, which decreases the "CRT" register (one place forward pointer shift);
- block 71, which transmits a line of characters to the character generating circuit 4;
- block 72, which checks whether the pointer is positioned at the end of a line.

The "YES" output of block 72 activates block 73, which sets the pointers at the start of the next line, and block 74, which tr(ansmits a line of characters to the character generating circuit 4.

The "NO" output of block 72 and block 74 supply an enabling signal to block 2 in Fig. 3. The "SHI" output from block 41 in Fig. 4 activates block 75, which modifies the "SHIFT" function bit (first or second function group selection on the keyboard) and supplies an enabling signal to block 74.

6

The "PB" signal from block 43 in Fig. 4 activates block 76, which increases the content of counter "CRT" (pointer one place back shift), and block 77, which checks whether the pointer was positioned at the start of a line.

The "NO" output activates block 74, while the "YES" output activates, in turn, block 78, which transmits a line of characters to the character generating circuit 4, and block 79, which sets the pointers at the end of the previous line. The output of block 79 supplies an enabling signal to block 74.

To give a clearer description, the following is a summary of the operating features of the blocks mentioned above

When the "TAC" function key is pressed, the complete message recorded beforehand in the RAM appears on the screen.

At the same time, the control unit is set for compiling a new message or altering or completing the existing one. The pointer character "_" in the top left-hand corner indicates where any newly entered character will be inserted.

The user may cancel the message entirely ("CLEAR" key) or shift the pointer as required for compiling the message using the pointer shift keys (back, forward, next line, etc.).

The "SHIFT" key provides for inserting letters or numbers and punctuation marks. When operated, the pointer character changes to inform the user, by means of a visual aid, which group of characters has been selected ("_" for letters, "+" for numbers). The pointer also changes colour whenever the "COL" key is pressed (white, red, yellow, magenta) to remind the user which colour has been selected for display.

Each character entered is automatically stored in the memory. Furthermore, whenever a key is operated (characters, pointer shift, etc.), the content of the present line is transmitted to the character generating circuit. Transmitting a whole line each time is the best compromise between transmission speed and the number of connections required and also guarantees constant character alignment.

Furthermore, transmission is synchronous with vertical return so as to avoid any visible interference on the screen.

The scratch pad function also includes two fixed messages, generated by the control unit regardless of the message compiled by the user.

Both are called up alternately whenever the "PRG" key is operated. The first concerns the more common receiver operating instructions and consists of a full page message memorised in the ROM, as opposed to the RAM, on the microcomputer during masking. The second corresponds to the entire group of display characters produced by the microcomputer unit (all the possible 8-bit data values displayed by the character generating circuit in 4 groups of 64 characters in 4 colours over 8 lines) which serves as a memo for the user and for making a fast check of correct circuit operation during shop testing.

In the example shown, a special meaning has been assigned to the last line in the scratch pad, which may be used for memorizing special dates, such as birthdays, anniversaries, appointments, etc.

This is usually displayed and may be compiled and altered in the same way as other lines in the pad.

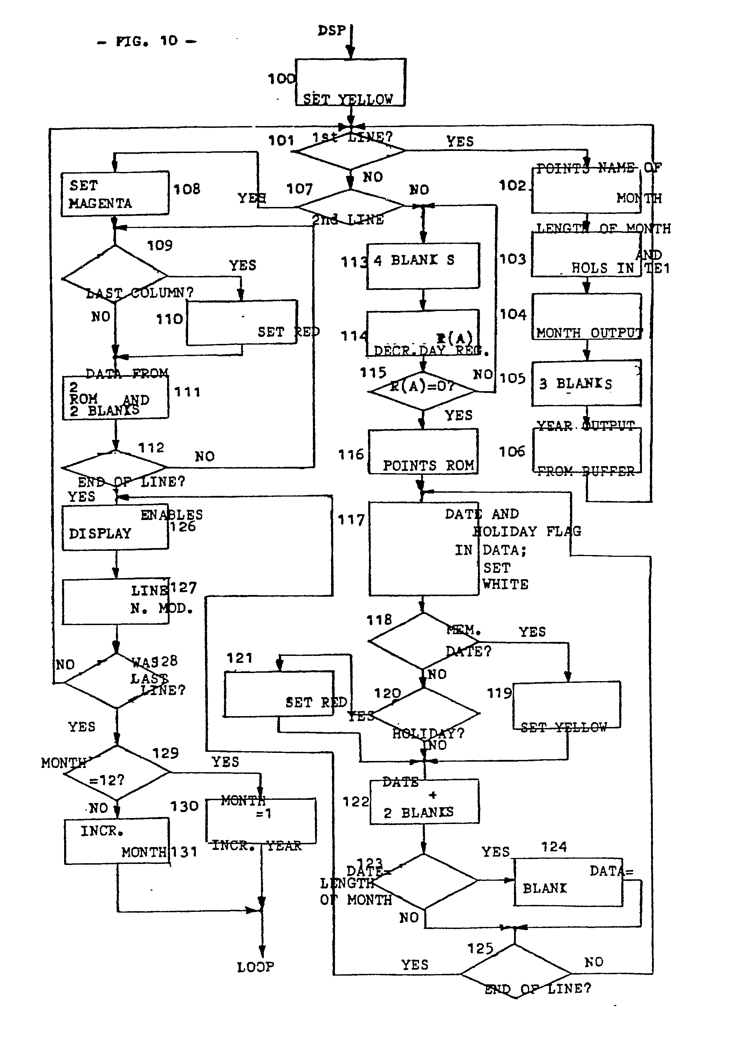

Furthermore, if the dates are represented by: NN/MM or by two figures indicating the number of the month, they are automatically recognised and shown whenever the calendar of a particular month is called up. However this will be described in more detail when we get to Fig. 10.

Fig. 8 shows data entry (month and year) for the calendar call-up function.

The "CALE" signal from block 12 in Fig. 3 activates block 80, which checks whether the "TAS" register contains a prearranged "CAL" value (i.e. whether the calendar function button has just been operated). The "NO" output activates, in turn, block 81, which memorises the operated key code in a cell on the RAM memory BUFFER inside the microcomputer, and block 82, which alters the content of a digit count register.

The "YES" output of block 80 activates, in turn, block 83, which assigns an initial value to the said digit count register, and block 84, which memorises the "??/????" characters codes in the said memory buffer.

Blocks 82 and 84 both activate:
- block 85, which assigns initial values to pointer registers for locating a given cell in the ROM memory and the initial cell in the said memory buffer;
- block 86, which takes the character line data from the said ROM memory and buffer and transmits it to the character generating circuit 4;
- block 87, which checks whether the data entered is the last figure in the number of the year.

The "YES" output of block 87 supplies a "CALEN" signal to the blocks described later in connection with Fig. 9. The "NO" output supplies a signal for activating block 2 in Fig. 3 (await new data).

Fig. 9 shows how Easter and the calendar of a given month are calculated for the set year.

The "CALEN" signal from block 87 in Fig. 8 activates block 90, which checks whether the set month number (1-12) is acceptable; the "YES" output activates block 91, which checks whether the century number falls within a given range (16-24), while the "NO" output of blocks 90 and 91 activate in turn:

- block 92, which assigns limit numbers 1 or 12 to the number of the month and 1600 or 2499 to the number of the year;
- block 93, which supplies an error signal.

The "YES" output of block 91 and the output of block 93 activate in turn:

- block 94, which converts the month number into a binary value and memorises it in the "MES" register;
- block 95, which, starting from the year and century number, calculates the date of Easter Sunday using the known Gauss formula and memorises it in the "TE1" register;
- block 96, which, starting from the date of Easter Sunday, calculates the first day in the required month (1 = Monday, 7 = Sunday) and memorises it in a provisional register "R(A)";
- block 97, which checks whether the number of the month read by the RAM memory tallies with that of the required month.

The "YES" output of block 97 (indicating that the requested month is among the dates to be remembered) activates block 98, which memorises the number of the day to be remembered in a "SPAD" register.

Block 98 and the "NO" output of block 97 activate block 99, which checks whether the date to be remembered is the last one in the RAM memory.

The "NO" output of block 99 activates block 97 again, while the "YES" output supplies a "DSP" signal to the next blocks in Fig. 10.

The latter shows block diagrams of elementary logic functions performed by the control unit for displaying a calendar page. The "DSP" signal from block 99 in Fig. 9 activates block 100, which sets the colour yellow and activates block 101, which checks whether it is the first line. The "YES" output of block 101 (line containing the name of the month and the year) activates in turn:

- block 102, which points to the name of the month in the ROM;
- block 103, which reads the length of the month and any holidays from the ROM and memorises them in the TE1 register;
- block 104, which sends the month name codes to the character generating circuit 4;
- block 105, which sends 3 blank codes to the character generating circuit 4;
- block 106, which sends the year number codes from the memory buffer to the character generating circuit 4.

The output of block 106 supplies a signal for activating block 101, the "NO" output of block 101 activates block 107, which checks whether it is the second line.

The "YES" output of block 107 (line containing abbreviations of the days of the week: MO, TU, WE, TH, FR, SA, SU) activates block 108, which sets the colour magenta, and block 109, which checks whether it is the last column. The "YES" output (Sundays) activates block 110, which sets the colour red, while the "NO" output and the output of block 110 activate, in turn, block 111, which sends 2 data from the ROM and 2 blanks to the character generating circuit 4, and block 112, which checks whether it is the end of a line.

The "NO" output of block 112 supplies an enabling signal to block 109, while the "YES" output of block 112 activates in turn:

- block 126, which enables the character generating circuit 4 for display;
- block 127, which modifies the line number;
- block 128, which checks whether it was the last line.

The "NO" output of block 128 (incomplete calendar page) supplies a signal for activating block 101, while the "YES" output of block 128 (complete page; increment month and year for rotating calendar) activates block 129, which checks whether the number of the month is 12. The "NO" output of block 129 activates block 131, which increments the number of the month, while the "YES" output activates block 130, which assigns a 1 to the number of the month and increments the number of the year.

The outputs of blocks 130 and 131 supply a signal for activating block 2 in Fig. 3 (end of calendar, await new instructions; if the "CROT" key has been pressed, after a certain length of time, the "CALEN" signal is generated again and the next month's calendar displayed on the screen).

The "NO" output of block 107 activates in turn:

- block 113, which sends 4 blanks to the character generating circuit 4;
- block 114, which decreases the content of the first day of the week register R(A);
- block 115, which checks whether the content of the R(A) register is zero.

The "NO" output of block 115 supplies an enabling signal to block 113, while the "YES" output activates in turn:

- block 116, which sets the pointer at the beginning of a number table in the ROM;
- block 117, which memorises the date and information indicating a possible holiday in the "DAT"

8

register and sets the colour white;
- block 118, which checks whether the day is one of the dates to be remembered in the "SPAD" register.

The "YES" output of block 113 (day = date to be remembered) activates block 119, which sets the colour yellow, while the "NO" output activates block 120, which checks whether the day in question is a holiday.

The "NO" output of block 120 activates block 121, which sets the colour red.

Blocks 119 and 121 and the "NO" output of block 120 activate, in turn, block 122, which sends "DATA" relative to the day of the month and 2 blanks to the character generating circuit 4, and block 123, which checks whether the date corresponds with the length of the month.

The "YES" output of block 123 activates block 124, which assigns the "DATA" a blank code (to fill in with blanks after the last day of the month).

Block 124 and the "NO" output of block 123 activate block 125, which checks whether it is the end of a line. The "NO" output activates block 117, while the "YES" output activates block 126.

Operation of the microcomputer control unit in connection with receiver functions is shown more clearly in the block diagrams in Fig. 11, 12, 13 and 14.

Fig. 11 shows operation mode selection (favourite programme selection, memorisation, etc.), "SHIFT" and memory page switch functions, return to normal television operation and memorisation of programme-associated station labels.

The "STAR" signal in Fig. 11 from block 13 in Fig. 3 activates block 130 which checks whether the operated key corresponds to a preset "DSP" code (return to normal operation of the set).

The "YES" output of block 130 activates block 150, which checks whether, instead of the key number, the buffer contains the "?" code.

The "YES" output of block 150 activates block 151, which recovers the key number from one of the internal "SPAD" registers.

The "YES" output of block 152 activates block 154, which clears the label in the buffer. The "YES" output of block 153 activates block 155, which recovers the channel number from the "SPAD".

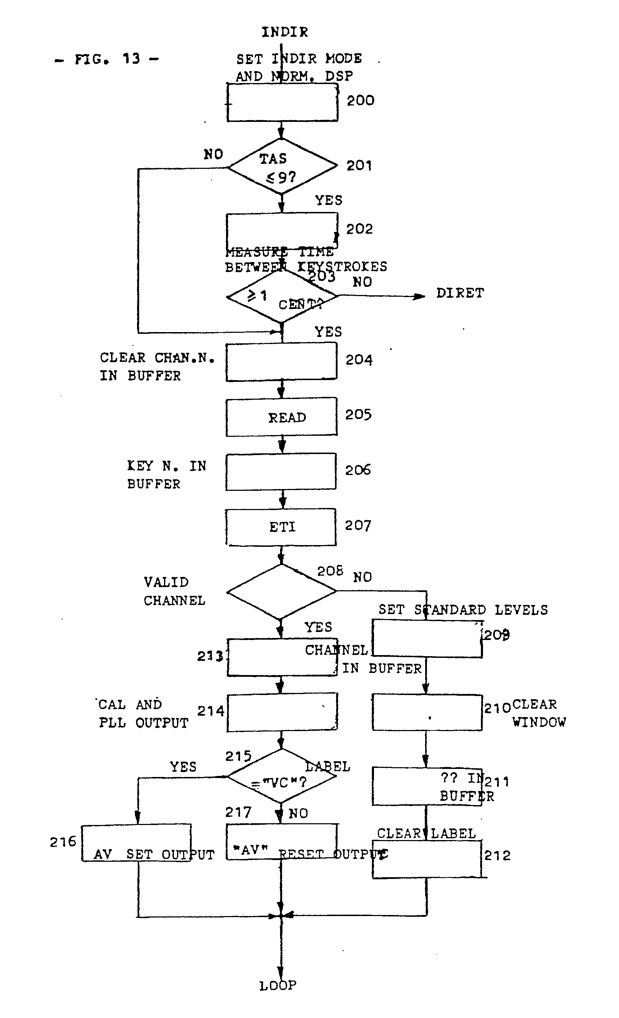

The outputs of blocks 151 and 154 and the "NO" output of block 153 activate block 156, which checks whether the key number is between 0 and 9. The "YES" output supplies an "INDIR" signal to the blocks in Fig. 13, while the "NO" output and the output of block 155 supply a "DIRET" signal to the next receiver blocks for selecting a station in the usual way on the basis of a given transmission standard channel number.

The "NO" output of block 130 activates block 131, which checks whether the operated key corresponds to a given "SHIFT" code.

The "YES" output of block 131 activates block 133, which checks whether the "SHIFT" function is 1; the "YES" output activates block 134, which zeroes the bit, while the "NO" output activates block 135, which sets the bit to 1. Blocks 134 and 135 supply a signal for activating block 163, which transmits the words "CHANNEL" and "KEY" to the character generating circuit 4 together with the memory page, channel and programme numbers and a label, if there is one.

A typical display in this case is:

```
P3

CHANNEL 42

KEY        6 GRP
```

The "NO" output of block 131 activates block 132, which checks whether the operated key corresponds to a given "PAG" code.

The "YES" output of block 132 activates, in turn, block 136, which increments the page number within a 1-3 range, block 137, which memorises the page number in the buffer, and display block 163.

The "NO" output of block 132 activates block 138, which checks whether the operated key corresponds to a given "PRG" code.

The "YES" output of block 138 activates block 139, which checks whether the operated key corresponds to a code from 11-13; the "YES" output supplies a "FINET" signal to the next blocks on the set, which perform a tuning correction, while the "NO" output activates, in turn, block 140, which saves the operated key in a "MOO" register, and block 141, which checks whether the "MOO" register contains a prearranged 19 code.

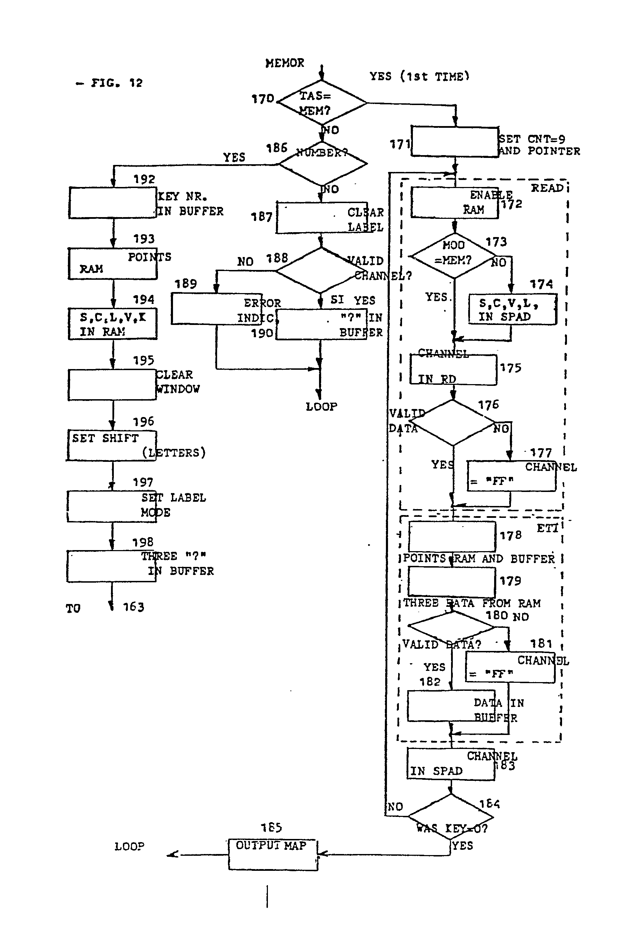

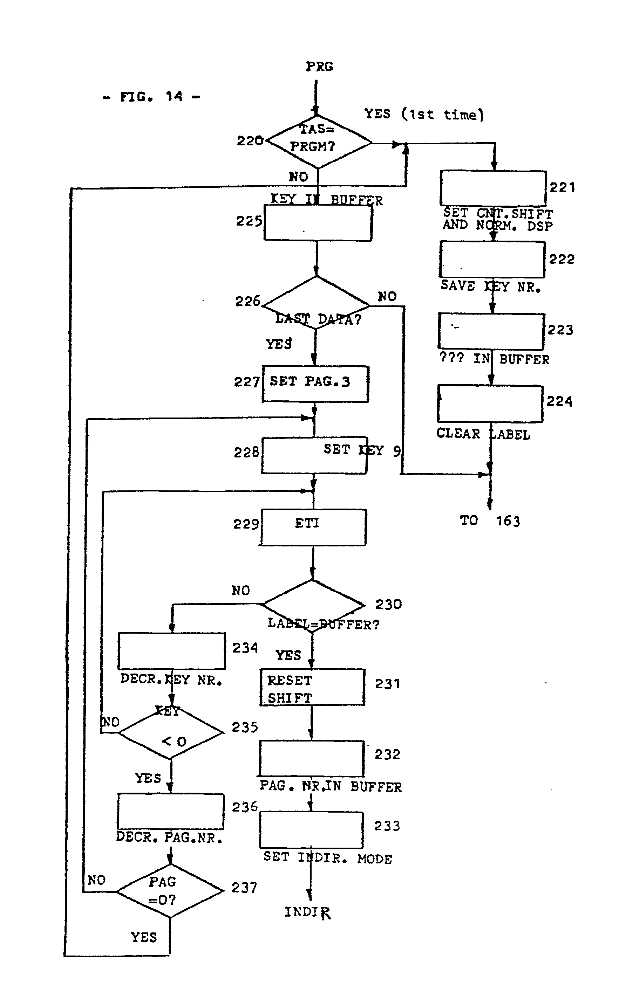

The "YES" output of block 141 supplies a "MEMOR" signal to the blocks in Fig. 12, while the "NO" output supplies an enable signal to block 142, which checks whether the "MOO" register contains a prearranged code 48. The "YES" output supplies a "PRG" signal to the blocks in Fig. 14, while the "NO" output supplies a signal to the next blocks in Fig. 13.

"NO" output of block 138 activates, in turn, block 143, which memorises the operated key in register "TE1", and block 144, which checks whether the "MOO" register contains a prearranged code 49 (label memorisation).

The "NO" output of block 144 activates in turn:
- block 145, which checks whether the "TE1" register contains 19 (memorisation);
- block 146, which checks whether the "TE1" register is between 0 and 9;
- block 148, which checks whether the "TE1" register is below a preset value of 48;
- block 149, which checks whether the "TE1" register is over a preset value of 29.

The "YES" output of block 146 activates block 147, which saves the operated number in the buffer and supplies an enabling signal to block 141. "YES" output of block 145, 148 and 149 supply an enabling signal to block 139. The "NO" output of block 149 supplies a "RICER" signal to the next blocks on the set which automatically scan the memorised programmes and receivable channels.

The "YES" output of block 144 activates, in turn:
- block 157, which converts a pointer register to the label character in the buffer;
- block 158, which memorises the operated key in the buffer;
- block 159, which checks whether the entered data is the last (third character of the label).

The "YES" output of block 159 activates, in turn:
- block 160, which points to a cell in RAM memory 7 of Fig. 1 corresponding to the first character of the selected page and programme label:
- block 161, which memorises the three label data in the next three RAM cells;
- block 162, which resets the SHIFT bit and normal programme call-up mode.

Block 162 supplies a signal for activating display block 163 and for generating the "LOOP" signal for awaiting new instructions.

Fig. 12 shows map display of the channels on a memory page and memorisation of channel data for assigning it to a given key.

The "MEMOR" signal from block 141 in Fig. 11 activates block 170, which checks whether the operated key corresponds to a preset "MEM" value (memorisation button).

The "NO" output of block 170 (first time the "MEM" key is operated) activates, in turn:
- block 171, which assigns an initial value of 9 to the counter register and points to an initial cell in RAM 7 in Fig. 1;
- block 172, which read-enables the RAM memory;
- block 173, which checks whether the "MOO" register contains a prearranged "MEM" value.

The "NO" output of block 173 activates block 174, which reads the tuning, colour, volume and brightness data from the RAM memory and memorises it in four "SPAD" registers.

Block 174 and the "YES" output of block 173 activate, in turn, block 175, which reads the channel number from the RAM memory and memorises it in the "RD" register, and block 176, which checks whether the read data is acceptable.

The "NO" output of block 176 activates block 177, which assigns a fictitious "FF" number to the channel, while the output of block 177 and the "YES" output of block 176 activate, in turn:
- block 178, which initialises pointer registers at a given RAM memory and buffer cell;
- block 179, which reads three label data from the RAM memory;
- block 180, which checks whether the said data is acceptable.

The "NO" output of block 180 activates block 181, which assigns an "FF" number to the channel, while the "YES" output activates block 182, which memorises the label data in the buffer.

Blocks 181 and 182 activate, in turn, block 183, which memorises the channel number in the "SPAD", and block 184, which checks whether the key count register contains a zero.

The "NO" output of block 184 supplies a signal for activating block 172, while the "YES" output supplies a signal for activating block 185, which sends the number of 10 channels on a given memory page to the character generating circuit 4 for displaying the map.

A typical channel map display is:

```
C   21  30  42

22  35  61  ??

??  ??  P3
```

which indicates that the third program page contains channels C, 21, 30, 42, 22, 35 and 61 associated to keys 0-6, while keys 7, 8 and 9 are unassigned.

Blocks 172 to 177 form a single block, which we shall call "READ", for reading all the programme data from the RAM memory. Blocks 178-182 also form a single block, which we shall call "ET1", for reading the label data from the RAM memory.

Both "READ" and "ET1" blocks will be used again later.

The "NO" output of block 170 activates block 186, which checks whether the operated key corresponds to a number from 0 to 9.

The "NO" output (second time the "MEM" key has been operated) activates, in turn, block 187, which clears the previous label in the buffer, and block 188, which checks whether the channel number is acceptable.

The "YES" output of block 188 activates block 190, which memorises an "?" in the buffer to show the receiver is waiting for the key number to be memorised, while the "NO" output activates block 189, which supplies an error signal to block 2 in Fig. 3 (await further instructions).

The "YES" output of block 186 (actual memorisation of a favourite programme) activates, in turn:
- block 192, which memorises the key number in the buffer;
- block 193, which points to the first cell in the RAM memory relative to the selected key number;
- block 194, which memorises tuning, colour, volume, brightness and channel data in five consecutive RAM cells;
- block 195, which clears the data in the buffer relative to the set data display window;
- block 196, which sets the SHIFT bit to 1 (letter of the alphabet setting);
- block 197, which memorises a label memorisation code (49) in the mode register;
- block 198, which memorises the "???" codes in the buffer.

Block 198 supplies a signal for activating block 163 in Fig. 11 (await three label characters) which are then memorised when blocks 157-162 in Fig. 11 (PET) are activated. A typical display during label memorisation is:

```
P3

CHANNEL  42

KEY        6 G??
```

In the example described each label consists of three characters which may be letters of the alphabet, numbers or blanks. A special significance has been assigned, however, to labels whose first two letters are "VC", i.e. "VCR". Besides providing for memory tuning the set to the video cassette recorder channel, these labels, whioh recall the video cassette recorder, cause the microcomputer control unit to activate an automatic "AV" (time constant) switch so as to provide for good picture stability in case of signals supplied from a video cassette recorder.

This particular operating mode will be described in more detail when we get to Fig. 13.

The "AV" switch activating function has been assigned to all the labels beginning with the letters "VC", so that switching is performed automatically both in case of a "VCR" label, associated with a video cassette recorder, and "VC1", "VC2", "VCX" labels, etc. for receiving a number of different stations with a switched time constant, e.g. private broadcasting stations, using commercial video cassette recorders.

Fig. 13 shows indirect programme selection, i.e. tuning into the 10x3 preferred stations corresponding to each of the 10 keys on the three pages.

The "INDIR" signal fromm the Fig. 11 blocks activates block 200, which provides for normal display and indirect call-up mode, and block 201, which checks whether the operated key corresponds to a number from 0 to 9.

The "YES" output of block 201 activates, in turn, block 202, which calculates the time interval between two number key operations, and block 203, which checks whether the interval is greater than a given length of time, i.e. one second.

The "NO" output of block 203 (two numbers operated in less than one second) supplies a "DIRET" signal to the next blocks on the receiver for selecting the station on the basis of the channel number, while the "YES" output of block 203 and the "NO" output of block 201 activate, in turn:
- block 204, which clears the channel number in the buffer;
- block 205 (same as the "READ" block in Fig. 12) which reads the programme data in the RAM memory;
- block 206, which memorises the key number in the buffer;
- block 207 (same as the "ET1" block in Fig. 12), which reads the label;
- block 208, which checks whether the channel number is acceptable.

The "NO" output of block 208 activates, in turn:
- block 209, which assigns standard volume, colour and brightness values;
- block 210, which clears the data relative to the window for displaying the data from the keyboard;
- block 211, which enters two "??" in the buffer;
- block 212, which clears the label in the buffer.

The "YES" output of block 208 activates, in turn:
- block 213, which memorises the channel number in the buffer;
- block 214, which, on the basis of the channel number, calculates the division number to be sent to the PLL circuit for exact tuning of the said channel;
- block 215, which checks whether the first two letters on the label are "VC".

The "YES" output of block 215 activates block 216, which activates the signal for the "AV" terminal, while the "NO" output of block 215 activates block 217, which disables the "AV" terminal signal. Blocks 212, 216 and 217 activate block 163 in Fig. 11 for display and awaiting further instructions.

Fig. 14 shows selection of a station using the label associated with it.

The "PRG" signal from block 142 in Fig. 11 activates block 220, which checks whether the operated key corresponds to a preset "PRGM" code. The "YES" output of block 220 (first time the "PRG" key is operated) activates, in turn:
- block 221, which provides for normal display, sets the SHIFT bit to 1 (letter of the alphabet setting) and assigns an initial value to the count register;
- block 222, which saves the key number in a "SPAD" register;
- block 223, which enters "???" in the buffer;
- block 224, which clears the label in the buffer.

The "NO" output of block 220 activates, in turn, block 225, which memorises the key number in the buffer, and block 226, which checks whether the data entered is the last (count register = 0).

Block 224 and the "NO" output of block 226 supply a signal for activating block 163 in Fig. 11 (await new data display).

The "YES" output of block 226 activates, in turn:
- block 227, which sets page N. 3;
- block 228, which sets key N. 9;
- block 229 (same as the "ET1" block), which reads the label in the RAM;
- block 230, which checks whether the read label corresponds to one memorised in the buffer.

The "YES" output of block 230 (label in the memory corresponds to the set one) activates , in turn:
- block 231, which zeroes the SHIFT bit (number setting);
- block 232, which memorises the page number in the buffer;
- block 233, which provides for normal indirect selection mode.

Block 233 supplies a signal for activating block 200 in Fig. 13.

The "NO" output of block 230 activates, in turn, block 234, which decreases the key number, and block 235, which checks whether the key number is less than zero. The "NO" output supplies a signal for activating block 229, while the "YES" output activates, in turn, block 236, which decreases the page number, and block 237, which checks whether the page number is equal to zero.

The "NO" output of block 237 (label not yet found among the 10 memorised programmes) supplies a signal for activating block 238, while the "YES" output (label not in the memory) supplies a signal for activating block 221 and the next ones (new label setting).

A typical display during label channel call-up is:

P1          +

12

CHANNEL 54

KEY          G??

To make things clearer, the following is a summary, for a number of operating modes, of the key functions on the panel and the data in the RAM memory and buffer.

The "receiver control" function is selected automatically when the set is turned on (block 1 in Fig. 3) or the "DSP" key is pressed.

A distinction must be made, however, as to whether the operating mode involves using a label or not.

Only in the first case is the "SHI" (Shift) key active (for selecting first or second case for the first 32 keys).

Furthermore, the label call-up setting ("PRG" key) or call-up of the label during memorisation provide for normal use of the letters which generally indicate an abbreviation of the broadcasting station. In all other cases, the SHIFT button is neglected and the keys on the keyboard assume the following functions:

| | |
|---|---|
| 0-9 | Selection of one of the 10 programmes memorised on the current memory page, or direct selection of 99 channels by pressing 2 numbers in less than one second. |
| (,) | Tuning corrections. |
| MEM | Memory map display and (second time pressed) memorisation setting. |
| VOL, LUM, SAT | Volume, brightness and colour saturation adjustments. |
| R1, R2, R3 | Buttons for starting 3 types of memorised programme or channel scanning operations. |
| PAG | Page number forward key. |

Memorised programmes are divided into three 10- programme pages, each programme indicated by 5 data and 3 letters for the label if there is one.

The said data is stored in the memory in consecutive blocks of 5 (programme 0 page 1, programme 1 page 1, ..., programme 9 page 3, label 0 page 1, ..., label 9 page 3).

The advantages deriving from the present invention are clearly apparent from the foregoing description.

For example, the microcomputer is used for performing a considerable number of functions, besides the control of the typical functions of the television receiver, so that its use is rendered optimal from the point of view of the cost/performance ratio.

Moreover, the said additional functions are obtained by the circuits according to the invention without rendering appreciably more heavy the hardware of the receiver.

Obviously many variants are possible.

Among these we mention the use of a different group of characters, comprising , for example, different graphic symbols, the use of a different format of the page of the scratch pad (for example, 6 lines of 40 characters each), or a different RAM memory capacity in order to contain a different number of pages of messages or a different number of memorised programs.

Other variants may consist in the selection of other colours for the writings, in particular in the case of the calendar, or in the choice of a different mode of presentation of the calendar (for example, more months at the same time), or in the use of labels comprising a different number of characters in the case of the selection of a program by menas of the mnemonic label.

EP 0 219 703 B1

Many other variants are possible without departing from the principles of novelty of the present invention.

For example, reference numeral 8 in Fig. 1 indicates a frequency-synthesis circuit of the PLL type for obtaining the tuning for a television receiver. It is clear that the invention may be used advantageously also in an electronic tuning circuit with memorisation of the voltage-synthesis type, in which each selected station has associated thereto and memorised a voltage in the form of a binary number which is then converted in a D/A converter into a tuning voltage to be applied to the variable reactance circuit contained in the tuning unit of the receiver. Therefore, the devices which obtain the memorisation of the said binary number may conveniently be dimensioned in such a manner as to contain also data relative to the labels to be associated to each memorised program.

Another variant may consist in displaying, besides the map of the memorised channels, also the map of the labels associated to the memorised channels. To obtain this, with reference to Fig. 12, it is sufficient that a block similar to block 183 memorises in particular inner registers the codes relative to the characters forming the labels, instead of the channel number.

Also, the remote control unit 1 provided with the alphanumerical keyboard and the receiver circuit 2, the control unit 3, the memory 7, eventually the circuit 8 and the character generating circuit 4 and the final video circuit 5, conveniently modified, may be designed not only for a colour type television set having the characteristics described hereinabove, but also for a colour television set having different functions, and eventually also for a black and white television set and generally for any device provided with a display screen, usable not only as described hereinabove, but also, in an exclusive or differently combinatorial manner, as note-book, calendar, etc., and generally as a device for displaying on a screen (of any type) pictures formed by alphanumerical characters.

Among the variants based on the principles of the present invention also the provision of a receiver of radioelectric signals in general may be mentioned, in which it is possible to receive stations emitting on pre-established frequencies, by simply requesting the menemonic label formed by some alphanumerical characters which has been memorised in association with the said station, according to the same principle which has already been described for the selection of television channels. In the case, for example, of a radio receiver set or a tuner, in which the device for tuning the receivable frequencies is obviously designed for the field of radio frequencies, the variant with respect to the block diagram of Fig. 1 consists only in the face that the character generator 4, or a character generator of a different, more simplified type, controls directly an alphanumerical character display device for the presentation of the said mnemonic labels. The selection of the preferred and previously memorised stations may take place by sending to the control unit 3 the code corresponding to the selected mnemonic label, either by means of the keyboard of the remote-control unit 1 , or by means of a keyboard connected directly to the control unit 3.

Finally the variant shown in Fig. 15 relates to a set comprising reproducer means for the reproduction of alphanumerical data, on a display screen, or reproducer printing means or vocal reproducer means, and in respect of the block diagram shown in Fig. 1 there is missing the frequency-synthesis PLL circuit 8. In this case the circuit 4 (which is a known circuit for the reproducer means 5) receives the signals from the control unit 3 and generates the pilot control signals for the reproducer means 5 which reproduce on a screen, or printing reproducers (or vocal reproducers), so as to obtain the 64 types of alphanumerical characters corresponding to the 64 keys which may be selevcted by means of the keyboard of the transmitter 1.

The operation of the set shown in Fig. 15 may be inferred from what has been described in the foregoing. Thus the apparatus shown in Fig. 1 may be used for different functions, including also tn note-book function for memorizing determined data and reproducing them at the desired moment, or the calendar function for obtaining data of the type described already in the foregoing, with the advantage of having the control keyboard 1 freely movable, without to be constrained to a fixed and limited position relative to the set.

Finally, among the further variants we mention the possibility of providing in the operating unit as many keys as the characters to be reproduced, without having to use a shift key for creating all the signals necessary to reproduce all the characters.

## Claims

1. Television receiver comprising a control unit (3) connected to circuit means (4,5) for controlling the display of alphanumerical characters, connected to television signal tuning means (8), to first electronic memorizing means (7) for memorizing data relative to the tuning of said television signals, and to an operating unit (1,2) for receiving data from the user, characterized in that said operating unit (1,2) comprise means to generate an alphanumerical set of characters, that additional groups of cells in said first electronic memorizing means (7) are provided to memorize a plurality of alphanumerical identifying labels, each one composed of a plurality of characters, that at least one group of cells in said first memorizing means (7), containing said data relative to the tuning of a television signal, can be associated with a correspondent additional group of cells in said first memorizing means, containing one of said identifying labels, and that in response to a first coded control signal coming from said operating unit (1,2) and corresponding to one of said identifying labels, the said control unit (3) searches said additional groups of cells in said first memorizing means (7) and extracts from the corresponding one group of cells the data relative to the tuning of said television signal and sends them to the said tuning means (8), in order to correctly tune the said station, and supplies the said circuit means (4,5) with codes apt to obtain the display of the said identifying label.

2. Television receiver according to claim 1 characterized in that the said circuit means (4,5) are of the type apt to display alphanumerical data formed by characters which can comprise all the letters in the alphabet and the numbers from 0 to 9.

3. Television receiver according to claims 1 and 2, characterized in that, in response to a second coded control signal, the said control unit (3) selects a first group of cells in the said first memorising means (7), associated to a second group of cells of said first memorising means (7) in which data relative to the tuning of said television signal can be memorised, and memorises therein a sequence of codes corresponding to the alphanumerical characters received from the said operating unit (1,2) and forming the said label representative of the station, so as to be capable of tuning in the said television signal by supplying the said control unit (3) with codes corresponding to the said label.

4. Television receiver according to claim 3, characterized in that the said first memorising means (7) comprise non-volatile read-write memory circuits capable of preserving the memorised data even in the event of lack of electric supply from the mains.

5. Television receiver according to claim 4, characterized in that, in response to a third coded control signal from the said operating unit (1,2), the said control unit (3) selects the said second group of cells on said first memorising means (7) and memorises therein data relative to adjustment levels of the said receiver, like brightness or volume.

6. Television receiver according to any one of the preceding claims, characterized in that the said control unit (3) sends control signals to a frequency synthesis circuit (8) and that the said tuning data is represented by a division number which must be supplied to a programmable divider on the frequency synthesis circuit (8) for obtaining the tuning of the desired television signal.

7. Television receiver according to any one of the clams from 1 to 5, characterized in that the said control unit (3) supplies control signals to a voltage synthesis circuit (8) and that the said tuning data is represented by a voltage value which must be supplied to a variable capacity circuit on a television signal selecting unit, for tuning into the desired television signal.

8. Television receiver according to any one of the claims from 3 to 5, characterized in that, in response to a fourth coded control signal from the said operating unit (1,2), the said control unit (3) prepares to receive from the said operating unit (1,2) a sequence of codes forming a possible label indicating the station to be received, selects the said first group of cells on the said first memory means (7), compares the said sequence with the content of the said first group of cells and, if the said sequence tallies with the content of a corresponding number of subsequent cells on the said first group of cells, extracts the said tuning data from the said associated second group of cells on the said first memorising means (7) and supplies it to a tuning unit for tuning into the desired station.

9. Television receiver according to any one of the claims from 3 to 5 characterized in that, in response to the said first coded control signal from the said operating unit (1,2), the said control unit (3) selects the said first group of cells on the said first memory means (7), compares the content of the said first group of cells on the said first memory means (7) with an assembly of possible values for said codes corresponding to characters contained in read-only-memory means and, in the event they tally, extracts the said tuning data from the said associated second group of cells on the said first memorising means (7) and supplies it to a tuning unit for tuning into the desired station, whereas in the event they do not tally the said data relative to the tuning is not transmitted to the said tuning unit.

10. Television receiver according to any one of the claims from 3 to 5, characterized in that, in response to the said second coded control signal from the said operating unit (1,2), the said control unit (3) supplies the said circuit means (4,5) with codes for displaying a standard message apt to request the user to supply the additional data relative to the said label representative of the desired station.

11. Television receiver according to claim 10, characterized in that, in response to each of the said additional data, the said control unit (3) sends every time to the said circuit means (4,5) the code corresponding to the character to be displayed, so as to obtain the reproduction of the said character on the display in place of the character forming the said standard message.

12. Television receiver according to claim 10, characterized in that the said control unit (3) counts the number of the said additional data relative to the said label representative of the station and, when the number reaches the value corresponding to the number of the characters forming the said standard message, memorises the received alphanumerical character codes in the said first group of cells on the said first memorising means (7).

13. Television receiver according to claim 12, characterized in that the said operating unit (1,2) has a function switch key which assigns a first or second meaning corresponding, in particular, to numbers (first) or letters of the alphabet (second) to certain keys on the said operating unit (1,2) and that the said control unit (3) memorises the switch setting in an internal memory register and changes it whenever it receives a control signal from the said switch key.

14. Television receiver according to claim 13, characterized in that the said control unit (3) assigns the said second meaning (letters of the alphabet) to the said switch setting in response to the said first or second coded control signal.

15. Television receiver according to claim 3, characterized in that, in response to a fifth coded control signal from the said operating unit (1,2), the said control unit (3) prepares to receive from the operating unit (1,2) a code corresponding to a significant program number the received station is to be assigned to, and, on the basis of the said number, prepares to select a block of cells from a third group of cells on the said first memorising means (7).

16. Television receiver according to claim 15, characterized in that, after receiving the said code corresponding to the significant program number, the said control unit (3) memorises the tuning data of the station in the said block of cells of the said third group and generates the said second coded control signal.

17. Television receiver according to claim 3, characterized in that, in response to the said first coded control signal from the said operating unit (1,2), the said control unit (3) compares the contend of the said first group of cells on the said first memorising means (7) with a predetermined combination of characters contained in read-only memory means, end in the event they tally, produces a switching signal for auxiliary circuits of the said receiver.

18. Television receiver according to claim 17, characterized in that the said combination is represented by codes corresponding to characters which indicate a video recorder (VC) and that the said switching signal serves to control a switching in circuits of the said receiver, in particular synchronization circuits, which switching is apt to improve the reproduction of signals from video recorders.

19. Television receiver according to any one of the preceding claims, characterized in that the operating unit (1,2) is of the telecontrol type and that it comprises an alphanumerical keyboard apt to generate at least as many coded control signals as the characters which can be generated by the said circuit means (4,5) and displayed on the screen.

**20.** Television receiver according to claim 19, characterized in that the operating unit (1,2) has a number N of keys lower than the number of the coded control signals to be generated and at least e key which serves, in combination with the remaining N-1 keys, to generate all the said coded control signals.

**21.** Television receiver according to claim 19, characterized in that the operating unit (1,2) has a number N of keys at least equal to the number of the coded control signals to be generated.

**22.** Television receiver according to any of the claims from 19 to 21, characterized in that the operating unit (1,2) comprises a telecontrol transmitter (1) comprising the said alphanumerical keyboard and circuits for coding and transmitting by air and a receiver circuit (2) comprising an amplifier.

**23.** Television receiver according to claim 22, characterized in that the said coding and transmitting circuit of the said operating unit (1,2) comprises an integrated circuit MC 14497 and that the said receiver circuit comprises an integrated circuit TBA 2110.

## Revendications

**1.** Récepteur de télévision comprenant une unité de commande (3) reliée à des moyens de circuit (4,5) pour commander l'affichage de caractères alphanumériques, à des moyens d'accord de signaux de télévision (8), à des premiers moyens de mémoire électronique (7) pour mémoriser des données relatives à l'accord desdits signaux de télévision, et à une unité opérative (1,2) recevant des données de l'utilisateur, caractérisé en ce que ladite unité opérative (1,2) comprend des moyens pour engendrer un jeu alphanumérique de caractères, en ce que des groupes additionels de cellules dans lesdits premiers moyens de mémoire électronique (7) sont pourvus pour mémoriser une pluralité d'indications alphanumériques d'identification, chacune composée par une pluralité de caractères, en ce que au moins un groupe de cellules dans lesdits premiers moyens de mémoire (7), contenant lesdites données relatives à l'accord d'un signal de télévision, peut être associé avec un correspondant groupe additionel de cellules dans lesdits premiers moyens de mémoire, contenant l'une desdites indications d'identification, et en ce qu' en réponse à un premier signal de commande codé de ladite unité opérative (1,2) et correspondant à une desdites indications d'identification, ladite unité de commande (3) cherche ledit groupe additionel de cellules dans lesdits premiers moyens de mémoire (7) et extrait du correspondant groupe de cellules les données relatives à l'accord dudit signal de télévision et les envoie auxdits moyens d'accord (8), en vue d'accorder correctement ladite station, et fournit auxdits moyens de circuits (4,5) les codes aptes à obtenir l'affichage de ladite indication d'identification.

**2.** Récepteur de télévision selon la revendication 1,
caractérisé en ce que lesdits moyens de circuit (4,5) sont du type apte à afficher des données alphanumériques formées de caractères qui peuvent comprendre toutes les lettres de l'alphabet et les nombres de 0 à 9.

**3.** Récepteur de télévision selon les revendications 1 et 2,
caractérisé en ce que, en réponse à un second signal de commande codé, ladite unité de commande (3) sélectionne un premier groupe de cellules dans lesdits premiers moyens de mémoire (7), associé à un second groupe de cellules desdits premiers moyens de mémoire (7) dans lequel des données relatives à l'accord dudit signal de télévision peuvent être mémorisées, et y mémorise une séquence de codes correspondant aux caractères alphanumériques reçus de ladite unité opérative (1,2) et formant ladite indication représentant la station, de façon de pouvoir accorder ledit signal de télévision en envoyant à ladite unité de commande (3) des codes correspondant à ladite indication.

**4.** Récepteur de télévision selon la revendication 3,
caractérisé en ce que lesdits premiers moyen de mémoire (7) comprendent des circuits de mémoire à lécture-écriture non volatile capables de préserver les données memorisées, même dans le cas d' une interruption de l'alimentation électrique de réseau.

**5.** Récepteur de télévision selon la revendication 4,
caractérisé en ce que, en réponse à un troisième signal de commande codé de ladite unité opérative (1,2), ladite unité de commande (3) sélectionne ledit second groupe de cellules dans lesdits moyens de

EP 0 219 703 B1

mémoire (7) et y memorise des données relatives aux niveaux d'ajustement dudit récepteur, telles que la brillance ou la volume.

6. Récepteur de télévision selon l'une quelconque des revendications précédentes, caractérisé en ce que ladite unité de commande (3) envoie des signaux de commande à un circuit de synthèse de fréquence (8), et en ce que lesdites données d'accord sont représentées par un nombre de division qui doit être fourni à un diviseur programmable dans le circuit de synthèse de fréquence (8) pour obtenir l'accord du signal de télévision souhaité.

7. Récepteur de télévision selon l'une quelconque des revendications 1 à 5, caractérisé en ce que ladite unité de commande (3) fournit des signaux de commande à un circuit de synthèse de voltage (8), et en ce que lesdites données d'accord sont représentées par une valeur de voltage qui doit être fournie à un circuit de capacité variable dans une unité de sélection de signaux de télévision, pour accorder le signal de télévision souhaité.

8. Récepteur de télévision selon l'une quelconque des revendications 3 à 5, caractérisé en ce que, en réponse à un quatrième signal de commande codé de ladite unité opérative (1,2), ladite unité de commande (3) se prépare à recevoir de l'unité opérative (1,2) une séquence de codes formant une possible indication représentant la station à recevoir, sélectionne ledit premier groupe de cellules dans lesdits premiers moyens de mémoire (7), compare ladite séquence avec le contenu dudit premier groupe de cellules et, si ladite séquence correspond au contenu d'un nombre correspondant de cellules successives dans ledit premier groupe de cellules, extrait lesdites données d'accord dudit second groupe associé de cellules dans lesdits premiers moyens de mémoire (7) et les fournit à une unité d'accord pour accorder la station souhaitée.

9. Récepteur de télévision selon l'une quelconque des revendications 3 à 5, caractérisé en ce que, en réponse audit premier signal de commande codé de ladite unité opérative (1,2), ladite unité de commande (3) sélectionne ledit premier groupe de cellules dans lesdits premiers moyens de mémoire (7), compare le contenu dudit premier groupe de cellules dans lesdits premiers moyens de mémoire (7) avec un ensemble de valeurs possibles pour lesdits codes correspondant à des caractères contenus dans des moyens de mémoire à lecture seule et, dans le cas de correspondance, extrait lesdites données d'accord dudit second groupe associé de cellules dans lesdits premiers moyens de mémoire (7) et les fournit à une unité d'accord pour accorder la station souhaitée, alors que, dans le cas de non-correspondance, lesdites données relatives à l'accord ne sont pas transmises à ladite unité d'accord.

10. Récepteur de télévision selon l'une quelconque des revendications 3 à 5, caractérisé en ce que, en réponse audit second signal de commande codé de ladite unité opérative (1,2), ladite unité de commande (3) fournit auxdits moyens de circuit (4,5) des codes pour afficher un message standard apte à demander à l'utilisateur de fournir les données additionelles, relatives à ladite indication représentant la station souhaitée.

11. Récepteur de télévision selon la revendication 10, caractérisé en ce que, en réponse à chacune desdites données additionelles, ladite unité de commande (3) envoie chaque fois auxdits moyens de circuit (4,5) le code correspondant au caractère à afficher, de façon d'obténir la reproduction dudit caractère sur le dispositif d'affichage à la place du caractère formant ledit message standard.

12. Récepteur de télévision selon la revendication 10, caractérisé en ce que ladite unité de commande (3) compte le nombre desdites données additionelles relatives à ladite indication représentant la station et, quand le nombre atteint la valeur correspondant au nombre des caractères formants ledit message standard, mémorise les codes des caractères aplhanumériques reçus dans ledit premier groupe de cellules dans lesdits premiers moyens de mémoire (7).

13. Récepteur de télévision selon la revendication 12, caractérisé en ce que ladite unité opérative (1,2) comporte une touche de commutation de fonction qui assigne une première ou une seconde signification correspondant, en particulier, à des nombres (première) ou des lettres de l'alphabet (seconde) à certaines touches sur ladite unité opérative (1,2) et en ce que ladite unité de commande (3) mémorise la position de commutation dans un registre interne de mémoire et la change chaque fois qu'elle reçoit un signal de commande de ladite touche de commutation.

14. Récepteur de télévision selon la revendication 13,
caractérisé en ce que ladite unité de commande (3) assigne ladite seconde signification (lettres de l'alphabet) à ladite positon de commutation en réponse audit premier ou second signal de commande codé.

15. Récepteur de télévision selon la revendication 3,
caractérisé en ce que, en réponse à un cinquième signal de commande codé de ladite unité opérative (1,2), ladite unité de commande (3) se prépare à recevoir de l'unité opérative (1,2) un code correspondant à un numéro significatif de programme auquel la station reçue doit être assigné, et, sur la base dudit numéro, se prépare à sélectionner un bloc de cellules d'un troisième groupe de cellules dans lesdits moyens de mémoire (7).

16. Récepteur de télévision selon la revendication 15,
caractérisé en ce que ladite unité de commande (3), après avoir reçu ledit code correspondant au numéro significatif de programme, mémorise les données d'accord de la station dans ledit bloc de cellules dudit troisième groupe et engendre ledit second signal de commande codé.

17. Récepteur de télévision selon la revendication 3,
caractérisé en ce que, en réponse audit premier signal de commande codé de ladite unité operative (1,2), ladite unité de commande (3) compare le contenu dudit premier groupe de cellules dans lesdits premiers moyens de mémoire (7) avec une combinaison prédéterminée de caractères contenus dans des moyens de mémoire à lecture seule, et, dans le cas de correspondance, produit un signal de commutation pour des circuits auxiliaires dudit récepteur.

18. Récepteur de télévision selon la revendication 17,
caractérisé en ce que ladite combinaison est représentée par des codes correspondant à des caractères qui indiquent un video enregistreur (VC) et en ce que ledit signal de commutation sert à commander une commutation dans des circuits dudit récepteur, en particulier des circuits de synchronisation, qui est apte à améliorer la reproduction de signaux de video enregistreurs.

19. Récepteur de télévision selon l'une quelconque des revendication précédentes, caractérisé en ce que l'unité operative (1,2) est du type à télécommande et en ce qu'elle comprend un clavier alphanumérique apte à engendrer au moins autant de signaux de commande codés que de caractères qui peuvent être engendrés par lesdits moyens de circuit (4,5) et affichés sur l'écran.

20. Récepteur de télévision selon la revendication 19,
caractérisé en ce que l'unité operative (1,2) comporte un nombre N de touches inférieur au nombre des signaux de commande codés à engendrer et au moins une touche qui sert, en combinaison avec les autres N-1 touches, à engendrer tous lesdits signaux de commande codés.

21. Récepteur de télévision selon la revendication 19,
caractérisé en ce que l'unité operative (1,2) comporte un nombre N de touches au moins égal au nombre des signaux de commande codés à engendrer.

22. Récepteur de télévision selon l'une quelconque des revendications 19 à 21, caractérisé en ce que l'unité operative (1,2) comprend un émetteur (1) comprenant ledit clavier alphanumériques et des circuits pour le codage et la transmission par l'air et un circuit récepteur (2) comprenant un amplificateur.

23. Récepteur de télévision selon la revendication 22,
caractérisé en ce que ledit circuit de codage et de transmission de ladite unité opérative (1,2) comprend un circuit intégré MC 14497 et en ce que ledit circuit récepteur comprend un circuit intégré TBA 2110.

# EP 0 219 703 B1

## Ansprüche

**1.** Fernsehempfänger, bestehend aus einer Steuereinheit (3), angeschlossen an Schaltungsmittel (4,5) zur Steuerung der Anzeige alphanumerischer Zeichen, angeschlossen an Fernsehsignal-Abstimmittel (8), an erste elektronische Speichermittel (7) zur Speicherung der sich auf die Abstimmung besagter Fernsehsignale beziehenden Daten, und an eine Bedienungseinheit (1,2) für den Empfang von Daten vom Benutzer, **dadurch gekennzeichnet,** daß die Bedienungseinheit (1,2) Mittel zur Erzeugung eines alphanumerischen Zeichensatzes aufweist, daß zusätzliche Gruppen von Speicherzellen in den ersten elektronischen Speichermitteln (7) zur Speicherung einer Vielfalt alphanumerischer Kennsätze enthalten sind und jeder aus einer Vielfalt von Zeichen besteht, daß mindestens eine Gruppe von Speicherzellen in den ersten Speichermitteln (7), die besagten sich auf die Abstimmung eines Fernsehsignals beziehenden Daten enthaltend, mit einer zugeordneten zusätzlichen Gruppe von Speicherzellen in den ersten Speichermitteln (7) assoziiert werden kann, die einen der besagten Kennsätze enthält, und daß in Antwort auf ein erstes codiertes Steuersignal , das von der Bedienungseinheit (1,2) kommt und einem der besagten Kennsätze entspricht, die Steuereinheit (3) die besagten zusätzlichen Gruppen von Speicherzellen in den ersten Speichermitteln (7) sucht und aus der entsprechenden Gruppe von Speicherzellen die sich auf die Abstimmung des Fernsehsignals beziehenden Daten ausliest und sie an die Abstimmittel (8) leitet, um auf den Sender korrekt abzustimmen, und den Schaltungsmitteln (4,5) geeignete Codes zuführt, um die Kennsätze angezeigt zu erhalten.

**2.** Fernsehempfänger nach Anspruch 1, dadurch gekennzeichnet, daß die Schaltungsmittel (4,5) des Typs sind, der zur Darstellung alphanumerischer Daten geeignet ist, die aus Zeichen gebildet werden, welche alle Buchstaben des Alphabets und die Zahlen von 0 bis 9 umfassen können.

**3.** Fernsehempfänger nach den Ansprüchen 1 und 2, dadurch gekennzeichnet, daß in Antwort auf ein zweites codiertes Steuersignal die Steuereinheit (3) eine erste Gruppe von Speicherzellen aus den ersten Speichermitteln auswählt, die mit einer zweiten Gruppe von Speicherzellen der besagten ersten Speichermittel (7) assoziiert sind, in welchen die sich auf die Abstimmung des Fernsehsignals beziehenden Daten gespeichert werden können, und außerdem eine Reihe von Codes entsprechend den von der Bedienungseinheit (1,2) erhaltenen alphanumerischen Zeichen speichert und die die Sendestation angebenden Kennsätze bildet, um imstande zur Abstimmung auf das entsprechende Fernsehsignal durch Zuführung von Codes mit korrespondierenden Kennsätzen an die Steuereinheit (3) sein zu können.

**4.** Fernsehempfänger nach Anspruch 3, dadurch gekennzeichnet, daß die ersten Speichermittel (7) nichtflüchtige Lese/Schreib-Speicherschaltungen umfassen, die fähig sind, die gespeicherten Daten sogar bei Stromausfall zu schützen.

**5.** Fernsehempfänger nach Anspruch 4, dadurch gekennzeichnet, daß in Antwort auf ein drittes codiertes Steuersignal von der Bedieneinheit (1,2) die Steuereinheit (3) die zweite Gruppe von Speicherzellen aus den ersten Speichermitteln (7) auswählt und darin in bezug auf die Abstimmpegel des Empfängers Daten, wie Helligkeit oder Lautstärke, speichert.

**6.** Fernsehempfänger nach einem der vorhergehenden Ansprüche, dadurch gekennzeichnet, daß die Steuereinheit (3) Steuersignale an eine Frequenzsyntheseschaltung (8) sendet, und daß die Abstimmdaten durch eine Teilungszahl angegeben werden, die an einen programmierbaren Teiler in der Frequenzsyntheseschaltung zum Erhalt der Abstimmung auf das gewünschte Fernsehsignal abgegeben werden muß.

**7.** Fernsehempfänger nach einem der Ansprüche 1 bis 5, dadurch gekennzeichnet, daß die Steuereinheit (3) Steuersignale an eine Spannungssyntheseschaltung (8) abgibt, und daß die Steuerdaten durch einen Spannungswert dargestellt werden, der an eine variable Kapazitätsschaltung in einer Fernsehsignal-Wähleinheit zur Abstimmung auf das gewünschte Fernsehsignal abgegeben werden muß.

**8.** Fernsehempfänger nach einem der Ansprüche 3 bis 5, dadurch gekennzeichnet, daß in Antwort auf ein viertes codiertes Steuersignal von der Bedienungseinheit (1,2) die Steuereinheit (3) sich darauf vorbereitet, von der Bedienungseinheit (1,2) eine Codefolge zu erhalten, die den möglichen Kennsatz

20

EP 0 219 703 B1

des zu empfangenen Senders bildet, und die erste Gruppe von Speicherzellen aus den ersten Speichermitteln (7) auswählt und besagte Folge mit dem Inhalt der ersten Gruppe von Speicherzellen vergleicht und, falls besagte Folge mit dem Inhalt der zugeordneten Anzahl der nachfolgenden Speicherzellen in der ersten Gruppe von Speicherzellen übereinstimmt, die Steuerdaten aus der assoziierten zweiten Gruppe von Speicherzellen in den ersten Speichermitteln (7) ausliest und sie an eine Abstimmeinheit zur Abstimmung auf den gewünschten Sender liefert.

9. Fernsehempfänger nach einem der Ansprüche 3 bis 5, dadurch gekennzeichnet. daß in Antwort auf das erste codierte Steuersignal der Bedienungseinheit (1,2) die Steuereinheit (3) die erste Gruppe von Speicherzellen in den ersten Speichermitteln (7) auswählt, den Inhalt der ersten Gruppe von Speicherzellen in den ersten Speichermitteln (7) mit den zusammengesetzten möglichen Werten der Codes vergleicht, die den in Festwertspeichern enthaltenen Zeichen entsprechen und, falls sie übereinstimmen, die besagten Abstimmdaten aus den angeschlossenen zweiten Gruppen von Speicherzellen in den Speichermitteln (7) ausliest und sie an eine Abstimmeinheit zur Abstimmung auf den gewünschten Sender abgibt, wobei im Falle, daß sie nicht übereinstimmen, die sich auf die Abstimmung beziehenden Daten nicht an die besagte Abstimmeinheit übertragen werden.

10. Fernsehempfänger nach einem der Ansprüche 3 bis 5, dadurch gekennzeichnet, daß in Antwort auf das besagte zweite codierte Steuersignal von der Bedienungseinheit (1,2) die Steuereinheit (3) an die besagten Schaltungsmittel (4,5) Codes für die Anzeige einer Standardnachricht mit dem Anforderungshinweis an den Benutzer abgibt, die zusätzlichen sich auf die besagte Kennung des gewünschten Senders beziehenden Daten zu liefern.

11. Fernsehempfänger nach Anspruch 10, dadurch gekennzeichnet, daß in Antwort auf jedes der besagten zusätzlichen Daten die Steuereinheit (3) jedesmal an die Schaltungsmittel (4,5) den Code schickt, der den darzustellenden Zeichen entspricht, um die Wiedergabe des jeweiligen Zeichens im Display anstelle des Zeichens, das die besagte Standardnachricht bildet, zu erhalten.

12. Fernsehempfänger nach Anspruch 10, dadurch gekennzeichnet, daß die Steuereinheit (3) die Anzahl der besagten zusätzlichen sich auf die besagte Senderkennung beziehenden Daten zählt und, wenn die Anzahl den Wert erreicht, der der Anzahl der Zeichen entspricht, die die besagte Standardnachricht bilden, die erhaltenen alphanumerischen Zeichencodes in der ersten Gruppe von Speicherzellen in den ersten Speichermitteln (7) speichert.

13. Fernsehempfänger nach Anspruch 12, dadurch gekennzeichnet, daß die Bedienungseinheit (1,2) eine Funktionsschalttaste aufweist, die einer ersten oder zweiten Bedeutung entsprechend insbesondere Ziffern (erste) oder Buchstaben des Alphabets (zweite) den bestimmten Tasten in der besagten Bedieneinheit (1,2) zuordnet, und daß die Steuereinheit (3) die Schaltstellung in einem internen Speicherregister speichert und wechselt, wann immer sie ein Steuersignal von der Funktionsschalttaste erhält.

14. Fernsehempfänger nach Anspruch 13, dadurch gekennzeichnet, daß die Steuereinheit (3) die zweite Bedeutung (Buchstaben des Alphabets) der besagten Schaltstellung in Antwort auf das erste oder zweite codierte Steuersignal zuordnet.

15. Fernsehempfänger nach Anspruch 3, dadurch gekennzeichnet, daß in Antwort auf ein fünftes codiertes Steuersignal von der Bedienungseinheit (1,2) die Steuereinheit (3) sich darauf vorbereitet, von der Bedienungseinheit (1,2) einen Code zu erhalten, der einer kennzeichnenden Programmnummer entspricht, die dem empfangenen Sender zugeordnet ist, und auf der Basis der besagten Nummer sich anschickt, einen Block von Speicherzellen aus einer dritten Gruppe von Speicherzellen in den ersten Speichermitteln (7) auszuwählen.

16. Fernsehempfänger nach Anspruch 15, dadurch gekennzeichnet, daß nach Empfang des besagten Codes, der der kennzeichnenden Programmnummer entspricht, die Steuereinheit (3) die Abstimmdaten des Senders in dem Block von Speicherzellen der dritten Gruppe speichert und das zweite codierte Steuersignal generiert.

17. Fernsehempfänger nach Anspruch 3, dadurch gekennzeichnet, daß in Antwort auf das erste codierte

21

Steuersignal von der Bedienungseinheit (1,2) die Steuereinheit (3) den Inhalt der ersten Gruppe von Speicherzellen in den ersten Speichermitteln (7) mit einer vorbestimmten Zeichenkombination, die in Festspeichern enthalten ist, vergleicht und im Falle der Übereinstimmung ein Schaltsignal für zusätzliche Schaltungen des besagten Empfängers erzeugt.

18. Fernsehempfänger nach Anspruch 17, dadurch gekennzeichnet, daß die Kombination durch Codes dargestellt wird, die den Zeichen entsprechen, die einen Videorecorder (VC) anzeigen, und daß das besagte Schaltsignal zur Steuerung eines Schaltkreises des besagten Empfängers dient, insbesondere Synchronisationsschaltungen, welches Umschalten geeignet ist, die Wiedergabe von Signalen des Videorecorders zu verbessern.

19. Fernsehempfänger nach einem der vorhergehenden Ansprüche, dadurch gekennzeichnet, daß die Bedienungseinheit (1,2) zu den Fernbedienungen gehört und daß sie eine alphanumerische Tastatur zur Erzeugung von mindestens so vielen codierten Steuersignalen wie Zeichen aufweist, die von den Schaltungsmitteln (4,5) generiert und auf dem Bildschirm dargestellt werden können.

20. Fernsehempfänger nach Anspruch 19, dadurch gekennzeichnet, daß die Bedienungseinheit (1,2) eine Anzahl von N Tasten, niedriger als die Anzahl der generierbaren codierten Steuersignale, und zumindest eine Taste aufweist, die dazu dient, in Kombination mit den verbleibenden N-J Tasten alle besagten codierten Steuersignale zu erzeugen.

21. Fernsehempfänger nach Anspruch 19, dadurch gekennzeichnet, daß die Bedienungseinheit (1,2) eine Anzahl von N Tasten aufweist, die zumindest der Anzahl der zu erzeugenden codierten Steuersignale gleich ist.

22. Fernsehempfänger nach einem der Ansprüche 19 bis 21, dadurch gekennzeichnet, daß die Bedienungseinheit (1,2) einen Fernbedienungssender (1), der die alphanumerische Tastatur und Schaltungen für die Codierung und für die drahtlose Übertragung aufweist, und eine Empfängerschaltung (2) mit einem Verstärker umfaßt.

23. Fernsehempfänger nach Anspruch 22, dadurch gekennzeichnet, daß die Codier- und Übertragungsschaltung der Bedienungseinheit (1,2) einen integrierten Schaltkreis MC 14497 aufweist, und daß die Empfängerschaltung einen integrierten Schaltkreis TBA 2110 aufweist.

22

– FIG. 1 –

- FIG. 2 -

EP 0 219 703 B1

— FIG. 3 —

- FIG. 4 -

- FIG. 5 -

CHECKS                    RET AND CI.

TC 1    YES    NO

(TO 21)              LAST
                    LINE? 67

50
POINTS START OF
LINE RAM

60
BLANK IN RAM

SELECT RAM   51

61
MODIFIES CRT COUNT.

52
DATA FROM RAM

64                   YES
                     62    NO
POINTS START OF
NEXT LINE            END OF LINE?
                         YES

53          YES
POINTER POS?         63    DAT=
                          CLEAR
NO                   PD          NO

DATA
POINTER + COL   54
+ SHIFT

65
TRANSMITS 1 LINE

55
DATA IN BUFFER

66
POINTS NEXT LINE

NO
56
END OF LINE?
YES

LOOP

AWAIT
VERT.   57
CONSENT

- FIG. 6 -

DATA FROM
BUFFER 8 TO   58
CRT GEN.

27

PF                SHI              PB

70    POINTER FWD

— 75    SHIFT BIT MOD.

76    DECREASE CRT COUNT.

71    TRANSMITS 1 LINE

77    WAS START OF LINE?    NO    YES

72    END OF LINE?    YES    NO

73    NEW LINE START SET

78    TRANSMITS 1 LINE

79    PREV. LINE END SET

74    TRANSMITS 1 LINE

— FIG. 7 —

LOOP

28

- FIG. 8 -

– FIG. 9 –

- FIG. 10 -

- FIG. 11 -

EP 0 219 703 B1

— FIG. 12

33

- FIG. 13 -

INDIR

SET INDIR MODE
AND NORM. DSP      200

TAS ≤9?      201

NO

YES

202

MEASURE TIME
BETWEEN KEYSTROKES

≥1 CENT?      203      NO      →      DIRET

YES

CLEAR CHAN.N.
IN BUFFER      204

READ      205

KEY N. IN
BUFFER      206

ETI      207

VALID
CHANNEL      208      NO      →      SET STANDARD LEVELS

YES      209

213      CHANNEL
IN BUFFER

CAL AND
PLL OUTPUT      214      210 CLEAR
WINDOW

215      LABEL
="VC"?      211 ?? IN
BUFFER

YES      NO

CLEAR LABEL

217      212

216      AV SET OUTPUT      "AV" RESET OUTPUT

LOOP

34

- FIG. 14 -

PRG

YES (1st time)

220 TAS= PRGM?

NO

KEY IN BUFFER

225

221 SET CNT.SHIFT AND NORM. DSP

222 SAVE KEY NR.

226 LAST DATA?

NO

YES

227 SET PAG.3

223 ??? IN BUFFER

224 CLEAR LABEL

228 SET KEY 9

229 ETI

TO 163

NO

230 LABEL=BUFFER?

YES

234 DECR.KEY NR.

231 RESET SHIFT

KEY

NO

235 < 0

232 PAG. NR.IN BUFFER

YES

236 DECR. PAG.NR.

233 SET INDIR. MODE

NO

237 PAG =0?

INDIR

YES

35